# EUROPEAN PATENT SPECIFICATION

(11) **EP 4 550 764 B1**
(45) Date of publication and mention of the grant of the patent: **30.09.2026**
(21) Application number: 23850239.7
(22) Date of filing: 14.06.2023
(51) Int. Cl.: H04M 1/02, G06F 1/16, F16C 11/04, H05K 1/14

(54) **ELECTRONIC DEVICE INCLUDING PROTECTIVE STRUCTURE FOR FLEXIBLE DISPLAY**
ELEKTRONISCHE VORRICHTUNG MIT SCHUTZSTRUKTUR FÜR FLEXIBLE ANZEIGE
DISPOSITIF ÉLECTRONIQUE COMPRENANT UNE STRUCTURE DE PROTECTION POUR UN ÉCRAN FLEXIBLE

(30) Priority: 02.08.2022 KR 20220096420; 08.08.2022 KR 20220098906
(43) Date of publication of application: 07.05.2025
(73) Proprietor: Samsung Electronics Co., Ltd., Suwon-si, Gyeonggi-do 16677 (KR)
(72) Inventor: WOO, Jeong, Suwon-si, Gyeonggi-do 16677 (KR)
(74) Representative: Gulde & Partner
(86) International application number: PCT/KR2023/008227
(87) International publication number: WO 2024/029729

(56) References cited:
- WO-A1-2022/019635
- WO-A1-2022/030775
- WO-A1-2022/071736
- KR-A- 20190 067 798
- KR-A- 20190 137 433
- KR-A- 20220 043 668
- US-A1- 2021 127 506
- US-A1- 2021 278 942
- US-A1- 2023 164 262

## Description

### [Technical Field]

Embodiments to be described later relate to an electronic device including a protective structure for a flexible display.

### [Background Art]

In order to increase portability of an electronic device, the electronic device may provide various types of a display. The electronic device may include a deformable flexible display in order to provide the various types of a display form. The flexible display may be configured to be foldable, slidable, or rollable.

Document US 2021/127506 A1, for example, describes a display device comprising a display module with a folding region, a fixing member under the folding region, and a first flexible printed circuit board (FPCB) between the display module and the fixing member, where a portion of the FPCB is attached to the fixing member.

Document WO 2022/019635 A1, for example, describes an electronic device and a control method therefor, wherein a shared screen and a private screen are provided together on an expandable flexible display.

Document WO 2022/071736 A1, for example, describes an electronic device comprising a flexible printed circuit board and a conductive member that is arranged to contact a conductive plate in a first state in which a first and second area of the display form a first angle.

### [Disclosure]

### [Technical Solution]

The present invention is directed to subject matter as defined in the claims.

According to an embodiment, an electronic device may include a first housing, a second housing, a hinge structure configured to rotatably couple the first housing and the second housing with respect to a folding axis, and a flexible display disposed on the first housing and the second housing. According to an embodiment, the electronic device may further include a first FPCB disposed on the first housing and the hinge structure, and a second FPCB disposed on the second housing and the hinge structure and spaced apart from the first FPCB. According to an embodiment, the electronic device may include a support plate disposed between the flexible display and the first FPCB and disposed between the flexible display and the second FPCB. According to an embodiment, each of a first area of the first FPCB facing a lateral surface of the second FPCB and a second area of the second FPCB facing a lateral surface of the first FPCB may be recessed from a surface facing the support plate toward the hinge structure to be spaced apart from the support plate.

According to an embodiment, an electronic device may include a first housing, a second housing, a hinge structure configured to rotatably coupled the first housing and the second housing with respect to a folding axis, and a flexible display disposed on the first housing and the second housing. According to an embodiment, the electronic device may include a first FPCB disposed on the first housing and the hinge structure, a second FPCB disposed on the second housing and the hinge structure and spaced apart from the first FPCB, and a support plate disposed between the flexible display and the first FPCB and disposed between the flexible display and the second FPCB. According to an embodiment, a first area of the first FPCB facing a lateral surface of the second FPCB may be thinner than a second area distinct from the first area of the first FPCB. According to an embodiment, a third area of the second FPCB facing a lateral surface of the first FPCB may be thinner than a fourth area distinct from the third area of the second FPCB.

### [Description of the Drawings]

FIG. 1 is a block diagram illustrating an electronic device 101 in a network environment 100 according to various embodiments.
FIG. 2A illustrates an example of an unfolding state of an electronic device according to an embodiment.
FIG. 2B illustrates an example of a folding state of an electronic device according to an embodiment.
FIG. 2C is an exploded view of an exemplary electronic device according to an embodiment.
FIG. 3A exemplarily represents a disposition of a hinge structure in an electronic device according to an embodiment.
FIG. 3B is a cross-sectional view in which a partial area of a hinge structure of an exemplary electronic device according to an embodiment is cut.
FIG. 3C is a cross-sectional view in which another partial area of a hinge structure of an exemplary electronic device according to an embodiment is cut.
FIG. 4 exemplarily represents a disposition relationship between a display and an input device, according to an embodiment.
FIG. 5 exemplarily represents a disposition relationship in which a space between an input device disposed under a third display area and a display is spaced apart, according to an embodiment.
FIG. 6 exemplarily represents a disposition relationship in which a portion of a layer of an input device disposed under a third display area is removed according to an embodiment.
FIGS. 7A and 7B exemplarily represents a disposition relationship in which a portion of a functional layer in contact with an input device disposed under a third display area is removed, according to an embodiment.
FIG. 8 exemplarily represents a disposition relationship in which an input device disposed under a third display area and a display are attached and a portion of the input device is removed, according to an embodiment.
FIGS. 9A and 9B represent a disposition of an exemplary input device, according to an embodiment.

### [Mode for Invention]

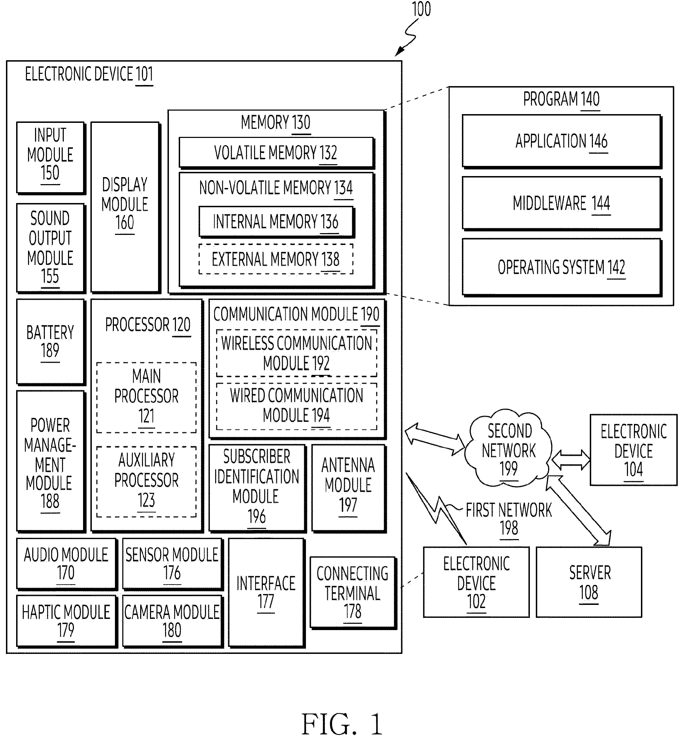

FIG. 1 is a block diagram illustrating an electronic device 101 in a network environment 100 according to various embodiments.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, an HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, an RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

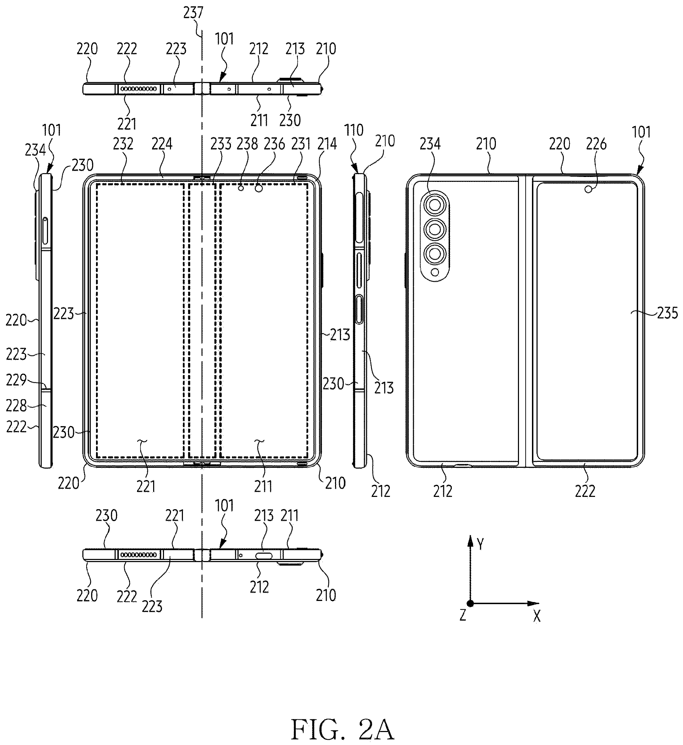

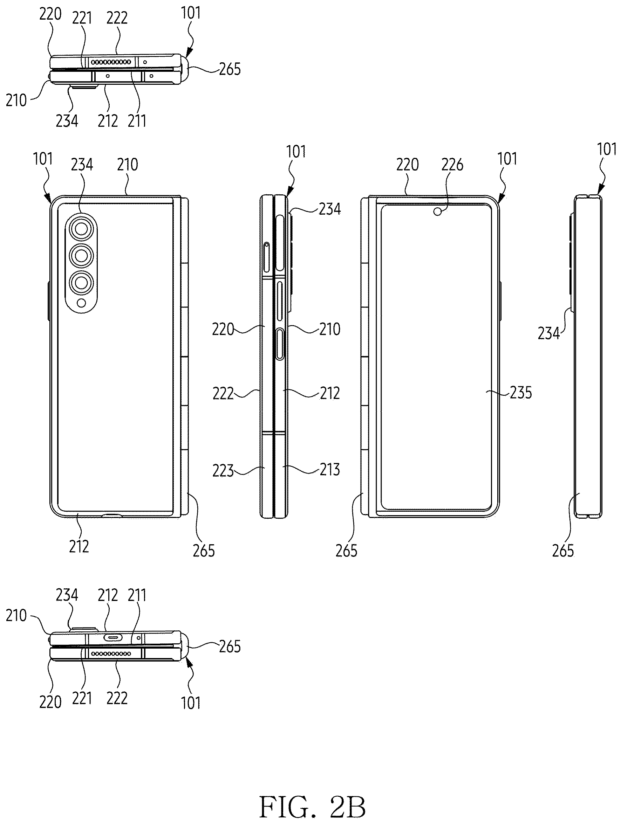

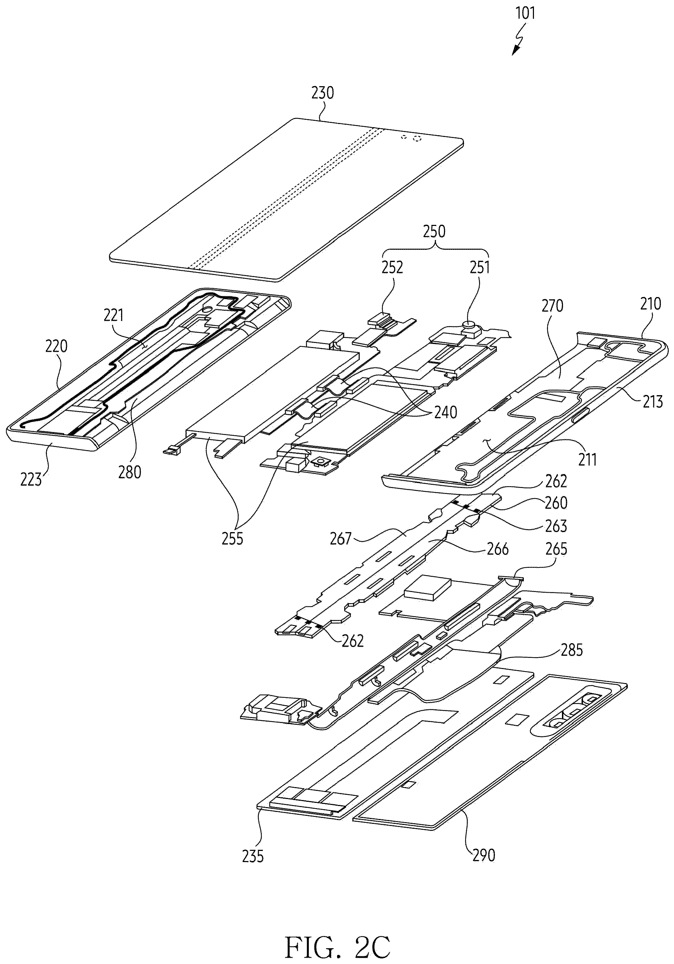

FIG. 2A illustrates an example of an unfolding state of an electronic device according to an embodiment, FIG. 2B illustrates an example of a folding state of an electronic device according to an embodiment, and FIG. 2C is an exploded view of an electronic device according to an embodiment.

Referring to FIGS. 2A, 2B, and 2C, an electronic device 101 may include a first housing 210, a second housing 220, and a flexible display 230. The electronic device 101 may be a device in which the first housing 210 and the second housing 220 may be in contact with each other. The electronic device 101 may be referred to as a foldable electronic device.

In an embodiment, the first housing 210 may include a first surface 211, a second surface 212 faced away from the first surface 211, and a first lateral surface 213 covering at least a portion of the first surface 211 and the second surface 212. According to an embodiment, the second surface 212 may further include at least one camera 234 exposed through a portion of the second surface 212. According to an embodiment, the first housing 210 may include a first protection member 214 disposed along a periphery of the first surface 211. According to an embodiment, the first housing 210 may provide a space formed by the first surface 211, the second surface 212, and the first lateral surface 213 as a space for mounting components of the electronic device 101. According to an embodiment, the first lateral surface 213 and a second lateral surface 223 may include a conductive material, a non-conductive material, or a combination thereof. For example, the second lateral surface 223 may include a conductive member 228 and a non-conductive member 229. The conductive member 228 may include a plurality of conductive members and may be spaced apart from each other. The non-conductive member 229 may be disposed between the plurality of conductive members. An antenna structure may be formed by a portion of the plurality of conductive members and a plurality of non-conductive members, or a combination thereof.

According to an embodiment, the second housing 220 may include a third surface 221, a fourth surface 222 faced away from the third surface 221, and the second lateral surface 223 covering at least a portion of the third surface 221 and the fourth surface 222. According to an embodiment, the fourth surface 222 may further include a display panel 235 disposed on the fourth surface 222. A camera 226 may be disposed to face the fourth surface 222 inside the second housing 220 to obtain an external image through the fourth surface 222. The camera 226 may be disposed under the display panel 235 and covered by the display panel 235. According to an embodiment, the camera 226 may be disposed under the display panel 235, and the display panel 235 may include an opening aligned with the camera 226 lens to transmit light from an outside to the camera 226. According to an embodiment, each of the first housing 210 and the second housing 220 may include each of the first protection member 214 and a second protection member 224. The first protection member 214 and the second protection member 224 may be disposed on the first surface 211 and the third surface 221 along a periphery of the flexible display 230. The first protection member 214 and the second protection member 214 may prevent foreign substance (e.g., dust or moisture) from introducing through a gap between the flexible display 230 and the first housing 210 and the second housing 220. The first protection member 214 may be disposed along a periphery of a first display area 231, and the second protection member 224 may be disposed along a periphery of a second display area 232. The first protection member 214 may be formed by being attached to the first lateral surface 213 of the first housing 210, or may be integrally formed with the first lateral surface 213. The second protection member 224 may be formed by being attached to the second lateral surface 213 of the second housing 220, or may be integrally formed with the second lateral surface 223.

According to an embodiment, the second lateral surface 223 may be rotatably (or pivotably) connected to the first lateral surface 213 through a hinge structure 260 mounted on a hinge cover 265. The hinge structure 260 may include a hinge module 262, a first hinge plate 266, and a second hinge plate 267. The first hinge plate 266 may be connected to the first housing 210, and the second hinge plate 267 may be connected to the second housing 220. According to an embodiment, the second housing 220 may provide a space formed by the third surface 221, the fourth surface 222 faced away from the third surface 221, and the lateral surface 223 covering at least a portion of the third surface 221 and the fourth surface 222 as a space for mounting components of the electronic device 101. According to an embodiment, the flexible display 230 may include a window exposed toward the outside. The window may protect a surface of the flexible display 230 and be formed as a protective layer to transmit visual information provided from the flexible display 230 to the outside. The window may include a glass material such as an ultra-thin glass (UTG) or a polymer material such as a polyimide (PI). According to an embodiment, the flexible display 230 may be disposed on the first surface 211 of the first housing 210 and the third surface 221 of the second housing 220 across the hinge cover 265. The flexible display 230 may include the first display area 231 disposed on the first surface 211 of the first housing 210, the second display area 232 disposed on the third surface 221 of the second housing 220, and a third display area 233 between the first display area 231 and the second display area 232. The first display area 231, the second display area 232, and the third display area 233 may form a front surface of the flexible display 230.

According to an embodiment, an opening may be formed in a portion of a screen display area of the flexible display 230, or a recess or an opening may be formed in a support member (e.g., bracket) supporting the flexible display 230. The electronic device 101 may include at least one or more of a sensor module 238 and a camera 236, aligned with the recess or the opening. For example, the first display area 231 may further include the camera 236 capable of obtaining an image from the outside through the portion of the first display area 231 and the sensor module 238 generating an electrical signal or a data value corresponding to an external environmental condition. According to an embodiment, at least one or more of the sensor module 238 and the camera 236 may be included on a rear surface of the flexible display 230 corresponding to the first display area 231 or the second display area 232 of the flexible display 230. For example, at least one of the camera 236 and the sensor module 238 may be disposed under the flexible display 230 and covered by the flexible display 230. At least one of the camera 236 and the sensor module 238 may not be exposed to the outside by being covered by the flexible display 230. However, it is not limited thereto, and the flexible display 230 may include an opening exposing the camera 236 and the sensor module 238 to the outside. Although not illustrated in FIGS. 2A and 2B, according to an embodiment, the flexible display 230 may further include a rear surface opposite to the front surface. According to an embodiment, the flexible display 230 may be supported by a first support member 270 of the first housing 210 and a second support member 280 of the second housing 220.

According to an embodiment, the hinge structure 260 may be configured to rotatably coupled the first support member 270 that forms the first housing 210 and is fastened to the first hinge plate 266, and the second support member 280 that forms the second housing 220 and is fastened to the second hinge plate 267.

According to an embodiment, the hinge cover 265 covering the hinge structure 260 may be at least partially exposed through a space between the first housing 210 and the second housing 220 while the electronic device 101 is in a folding state. In another embodiment, the hinge cover 265 may be covered by the first housing 210 and the second housing 220 while the electronic device 101 is in an unfolding state.

According to an embodiment, the electronic device 101 may be folded with respect to a folding axis 237 passing through the hinge cover 265. For example, the hinge cover 265 may be disposed between the first housing 210 and the second housing 220 of the electronic device 101 so that the electronic device 101 may be bent, curved, or folded. For example, the first housing 210 may be coupled to the second housing 220 through the hinge structure 260 mounted on the hinge cover 265 and may rotate with respect to the folding axis 237. For example, the hinge structure 260 may include the hinge modules 262 disposed at both ends of the first hinge plate 266 and the second hinge plate 267. Since the hinge module 262 includes hinge gears engaged with each other therein, the hinge module 262 may rotate the first hinge plate 266 and the second hinge plate 267 with respect to the folding axis. The first housing 210 coupled to the first hinge plate 266 may be connected to the second housing 220 coupled to the second hinge plate 267, and may rotate with respect to the folding axis by the hinge modules 262.

According to an embodiment, the electronic device 101 may be folded so that the first housing 210 and the second housing 220 may face each other by rotating with respect to the folding axis 237. According to an embodiment, the electronic device 101 may be folded so that the first housing 210 and the second housing 220 are stacked or overlapped with each other.

Referring to FIG. 2C, the electronic device 101 may include the first support member 270, the second support member 280, the hinge structure 260, the flexible display 230, a printed circuit board 250, a battery 255, the hinge cover 265, an antenna 285, the display panel 235, and a rear plate 290. According to an embodiment, the electronic device 101 may omit at least one of the components or may additionally include another component. At least one of the components of an electronic device 300 may be the same as or similar to at least one of the components of the electronic device 101 of FIGS. 1, 2A, or 2B, and a redundant description will be omitted below.

The first housing 210 and the second housing 220 may support a flexible display (e.g., the flexible display 230 of FIG. 2A). A flexible display panel may include a front surface that provides information by emitting light and a rear surface facing the front surface. In case that the first surface (e.g., the first surface 211 of FIG. 2A) of the first housing 210 faces the third surface (e.g., the third surface 221 of FIG. 2A) of the second housing 220, the flexible display panel may be in the folding state in which a surface in which the first display area 231 of the flexible display panel faces and a surface in which the second display area 232 of the flexible display panel faces face each other. In case that the first surface 211 of the first housing 210 and the third surface 221 of the second housing 220 face the same direction, the flexible display 230 may be in the unfolding state in which the first display area 231 and the second display area 232 of the flexible display 230 face the same direction.

According to an embodiment, the electronic device 101 may provide the unfolding state in which the first housing 210 and the second housing 220 are fully folded out by the hinge structure 260. The first support member 270 may switch the electronic device 101 into the folding state or the unfolding state by being connected to the second support member 280 through the hinge structure 260. By rotation of a hinge gear 263, the first support member 270 and the second support member 280 attached to the hinge plates 266 and 267 of the hinge structure 260 may operate. The hinge plates 266 and 267 may include the first hinge plate 266 coupled to the first support member 270 and the second hinge plate 267 coupled to the second support member 280. By the rotation of the hinge gear 263, the electronic device 101 may be switched into the folding state or the unfolding state.

The hinge structure 260 may include the hinge module 262, the first hinge plate 266, and the second hinge plate 267. The hinge module 262 may include the hinge gear 263 that makes the first hinge plate 266 and the second hinge plate 267 pivotable. The hinge gear 263 may rotate the first hinge plate 266 and the second hinge plate 267 while engaging with each other and rotating. The hinge module 262 may be a plurality of hinge modules. Each of the plurality of hinge modules may be disposed at both ends formed by the first hinge plate 266 and the second hinge plate 267.

The first hinge plate 266 may be coupled to the first support member 270 of the first housing 210, and the second hinge plate 267 may be coupled to the second support member 280 of the second housing 220. The first housing 210 and the second housing 220 may rotate to correspond to the rotation of the first hinge plate 266 and the second hinge plate 267.

The first housing 210 may include the first support member 270, and the second support member 280. The first support member 270 may be partially covered by the first lateral surface 213, and the second support member 280 may be partially covered by the second lateral surface 223. The first support member 270 may be integrally formed with the first lateral surface 213, and the second support member 280 may be integrally formed with the second lateral surface 223. According to an embodiment, the first support member 270 may be formed separately from the first lateral surface 213, and the second support member 280 may be formed separately from the second lateral surface 223. The first lateral surface 213 and the second lateral surface 223 may be formed by a metal material, a non-metal material, or a combination thereof, and may be used as an antenna.

The first support member 270 may be coupled to the flexible display 230 on a surface, and may be coupled to the rear plate 290 on another surface. The second support member 280 may be coupled to the flexible display 230 on a surface, and may be coupled to the display panel 235 on another surface.

The printed circuit board 250 and the battery 255 may be disposed between a surface formed by the first support member 270 and the second support member 280 and a surface formed by the display panel 235 and the rear plate 290. The printed circuit board 250 may be separated in order to be disposed on each of the first support member 270 of the first housing 210 and the second support member 280 of the second housing 220. A shape of a first printed circuit board 251 disposed in the first support member 270 and a shape of a second printed circuit board 252 disposed in the second support member 280 may be different from each other according to a space of an inside of the electronic device. Components for implementing various functions of the electronic device 10 may be mounted on the first printed circuit board 251 and the second printed circuit board 252. According to an embodiment, the components for implementing an overall function of the electronic device 101 may be mounted on the first printed circuit board 251, and on the second printed circuit board 252, electronic components for implementing a portion of functions of the first printed circuit board 251 may be disposed or components for driving the display panel 235 disposed on the fourth surface 222 may be disposed. The first printed circuit board 251 and the second printed circuit board 252 may be electrically connected by a flexible printed circuit board 240.

For example, the battery 255, which is a device for supplying power to at least one component of the electronic device 101, may include a non-rechargeable primary battery, or a rechargeable secondary battery, or a fuel cell. At least a portion of the battery 255 may be disposed on substantially the same plane as the printed circuit board 250. The surface of the printed circuit board 250 and the battery 255 formed as substantially the same plane may be disposed on a surface (e.g., a surface facing the second surface 212 and the fourth surface 222 or a surface facing the display panel 235 and the rear plate 290) of the first support member 270 and the second support member 280. For example, the flexible display 230 may be disposed on the first surface 211 and the third surface 221, and the printed circuit board 250 and the battery 255 may be disposed on the second surface 212 and the fourth surface 222 facing the surface on which the flexible display 230 is disposed.

In an embodiment, the antenna 285 may be disposed between the rear plate 290 and the battery 255. The antenna 285 may include, for example, a near field communication (NFC) antenna, a wireless charging antenna, and/or a magnetic secure transmission (MST) antenna. For example, the antenna 285 may perform short-range communication with an external device, or wirelessly transmit and receive the power required for charging.

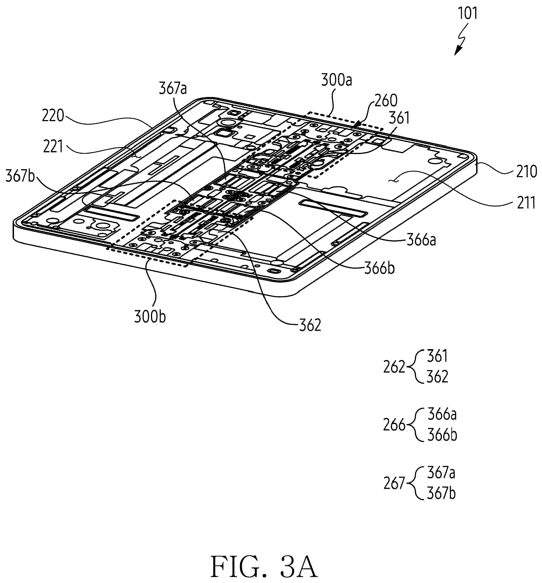

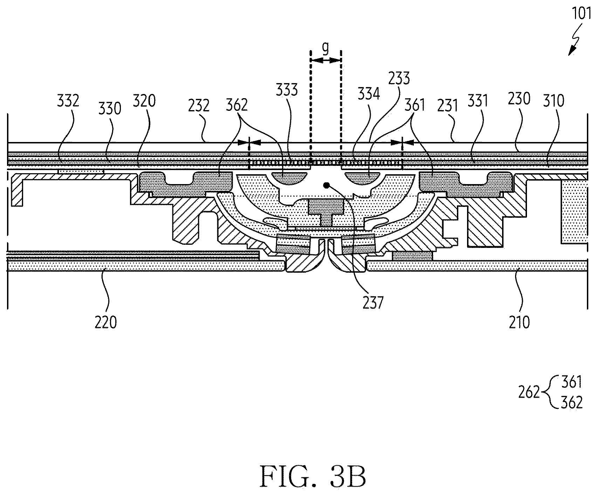

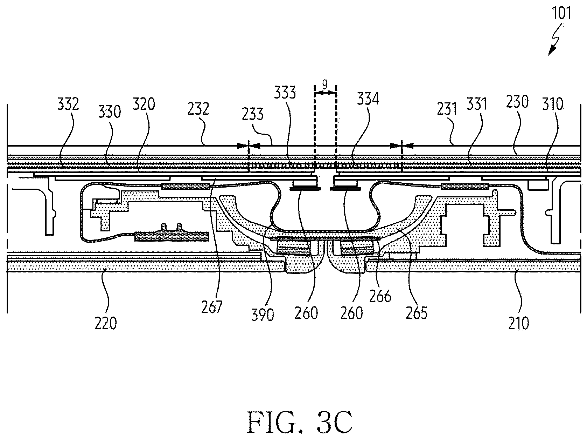

FIG. 3A exemplarily represents a disposition of a hinge structure in an electronic device according to an embodiment. FIG. 3B is a cross-sectional view in which a partial area of a hinge structure of an exemplary electronic device according to an embodiment is cut. FIG. 3C is a cross-sectional view in which another partial area of a hinge structure of an exemplary electronic device according to an embodiment is cut.

Referring to FIG. 3A, a hinge structure 260 may rotatably couple a first housing 210 and a second housing 220. For example, the first housing 210 may be rotatable with respect to the second housing 220 through the hinge structure 260. The second housing 220 may be rotatable with respect to the first housing 210 through the hinge structure 260.

According to an embodiment, the hinge structure 260 may include a hinge module 262 in which gears 263 (e.g., the hinge gear 263 of FIG. 2C) for rotation of the first housing 210 and the second housing 220 are disposed. The hinge module 262 may include a first hinge module 361 disposed in a portion of a periphery of each of the first housing 210 and the second housing 220 and a second hinge module 362 facing the first hinge module 361. The second hinge module 362 may be disposed in a portion of another periphery facing the periphery of each of the first housing 210 and the second housing 220 in which the first hinge module 361 of the first housing 210 and the second housing 220 is disposed. For example, the first hinge module 361 may be disposed in a first periphery area 300a of an inside of the electronic device 101, and the second hinge module 362 may be disposed in a second periphery area 300b of the inside of the electronic device 101.

According to an embodiment, the hinge structure 260 may include a first hinge plate 266 and a second hinge plate 267. The first hinge plate 266 may be connected to the first housing 210, and the second hinge plate 267 may be connected to the second housing 220. The hinge structure 260 may include hinge modules 262 disposed at both ends of the first hinge plate 266 and the second hinge plate 267. Since the hinge module 262 includes the hinge gear 263 engaged with each other therein, the hinge module 262 may rotate the first hinge plate 266 and the second hinge plate 267 with respect to a folding axis. Each of the first hinge plate 266 and the second hinge plate 267 may include a plurality of plates. For example, the first hinge plate 266 may include a first plate 366a and a second plate 366b. The first plate 366a may be in contact with the first hinge module 361, and the second plate 366b may be in contact with the second hinge module 362. The second hinge plate 267 may include a third plate 367a and a fourth plate 367b. The third plate 367a may be in contact with the first hinge module 361, and the fourth plate 367b may be in contact with the second hinge module 362.

According to an embodiment, the first plate 366a, the second plate 366b, the third plate 367a, and the fourth plate 367b may include a material having rigidity. For example, the first plate 366a, the second plate 366b, the third plate 367a, and the fourth plate 367b may include a metal material such as stainless used steel (SUS). The first hinge plate 266 and the second hinge plate 267 may support a portion of a third display area 233.

FIGS. 3B and 3C represents a disposition relationship between the hinge structure 260 and the third display area 233 disposed on the hinge structure 260 according to a cutting position. FIG. 3B is a cross-sectional view in which an area where the hinge module 262 is disposed is cut, and FIG. 3C is a cross-sectional view in which an area where the hinge plate 266 or 267 is disposed is cut.

Referring to FIGS. 3A and 3B, the electronic device 101 may not dispose hinge plates (e.g., the first hinge plate 266 or the second hinge plate 267) on the hinge module 262. For example, the hinge module 262 may not overlap the hinge plates 266 and 267 when a display 230 is viewed from above. For example, the hinge module 262 may be disposed adjacent to the hinge plates 266 and 267.

According to an embodiment, the electronic device 101 may include the display 230, a first FPCB 310, and a second FPCB 320 disposed on the hinge structure 260. For example, the first FPCB 310 and the second FPCB 320 may be disposed on the hinge module 262. The first FPCB 310 may be spaced apart from the second FPCB 320. A folding axis 237 may be disposed between the first FPCB 310 and the second FPCB 320. For example, the first FPCB 310 and the second FPCB 320 may be substantially symmetrical with respect to the folding axis 237. The support plate 330 may face the hinge structure 260 through a gap between the first FPCB 310 and the second FPCB 320.

According to an embodiment, the first FPCB 310 and the second FPCB 320 may be electrically connected through an FPCB 390 crossing the hinge structure 260. The first FPCB 310 and the second FPCB 320 may be at least a portion of an electronic component configured to perform a function. For example, the first FPCB 310 and the second FPCB 320 may be an input device, the first FPCB 310 may receive an input provided from a first display area 231, and the second FPCB 320 may receive an input provided in a second display area 232. The input provided in the area between the first FPCB 310 and the second FPCB 320 may receive the input based on information obtained through the portion of the first FPCB 310 or the second FPCB 320. For example, the first FPCB 310 and/or the second FPCB 320 may be an electromagnetic induction panel. The first FPCB 310 and/or the second FPCB 320 may receive an input signal from an external object. For example, the external object may be an electronic pen. The first FPCB 310 and/or the second FPCB 320 may receive the input signal through an electromagnetic interaction with the electronic pen. The first FPCB 310 and/or the second FPCB 320 may form an electromagnetic field based on a current applied to an internal conductive pattern. The electronic pen may form an electromagnetic field different from the electromagnetic field based on the current induced to a coil inside the electronic pen from the electromagnetic field. The first FPCB 310 and/or the second FPCB 320 may recognize the electromagnetic field formed from the electronic pen. The electronic device 101 may receive an input inputted into the display area 231, 232, and 233 based on recognizing the electromagnetic field formed from the electronic pen through the first FPCB 310 and/or the second FPCB 320. The input may be obtained based on the contact of the electronic pen in the display area 231, 232, and 233 or being positioned in a preset distance from the display area 231, 232, and 233.

According to an embodiment, the support plate 330 may include a first rigid area 331, a second rigid area 332, and a flexible area 333. The first rigid area 331 and the second rigid area 332 may be areas that form substantially a planar area. The flexible area 333 may be an area that may be deformed according to a change in a state of the electronic device 101.

According to an embodiment, the electronic device 101 may include the support plate 330 disposed between the first FPCB 310 and the flexible display 230 or between the second FPCB 320 and the flexible display 230. The support plate 330 may support the flexible display 230. The support plate 330 may include the first rigid area 331 supporting the first display area 231 of the display 230 and the second rigid area 332 supporting the second display area 232 of the display 230. The support plate 330 may further include the flexible area 3330 disposed between the first rigid area 331 and the second rigid area 332. The flexible area 333 may support the third display area 233. The flexible area 333 may be configured to be deformable corresponding to deformation of the third display area 233. The flexible area 333 may include a plurality of slits 334 extending in a direction parallel to the folding axis 237 to be deformed according to the deformation. The support plate 330 may include metal such as a carbon fiber reinforced polymer (CFRP), glass fiber reinforced plastics (GFRP), or the stainless used steel (SUS).

According to an embodiment, the first rigid area 331 may be disposed between the first FPCB 310 and the first display area 231. The second rigid area 332 may be disposed between the second FPCB 320 and the second display area 232. The flexible area 333 may be disposed on an area including a side of the first FPCB 310 facing the second FPCB 320 and an area including a side of the second FPCB 320 facing the side of the first FPCB 310. According to an embodiment, the hinge modules 361 and 362 may be spaced apart from the first FPCB 310 and/or the second FPCB 320 in a portion of the third display area 233.

Referring to FIGS. 3A and 3C, the electronic device 101 may include the hinge plates 266 and 267 connected to the hinge modules 361 and 362. The hinge plates 266 and 267 may be disposed between the hinge modules 361 and 362. For example, the hinge plates 266 and 267 may be positioned between the first periphery area 300a and the second periphery area 300b. The hinge plates 266 and 267 may be disposed adjacent to the hinge modules 361 and 362. The first hinge plate 266 may be disposed at a position corresponding to a portion of the first display area 231 and a portion of the third display area 233. For example, the first hinge plate 266 may support a portion of the first rigid area 331 and the flexible area 333. The second hinge plate 267 may be disposed at a position corresponding to a portion of the second display area 232 and a remaining portion of the third display area. For example, the second hinge plate 267 may support a remaining portion of the second rigid area 332 and the flexible area 333.

Referring to FIGS. 3B and 3C, the support plate 330 may face the hinge structure 260 (e.g., the hinge plates 266 and 267 or the hinge module 262) through a gap between the first FPCB 310 and the second FPCB 320. In the first periphery area 300a and the second periphery area 300b, the first hinge module 361 may be spaced apart from the second hinge module 362 at an interval g. In an area of the third display area 233 other than the first periphery area 300a and the second periphery area 300b, the first hinge plate 266 may be spaced apart from the second hinge plate 267 at the interval g. Due to an external impact, the third display area 233 may sag between the interval g. In the third display area 233, not only the flexible display 230 but also the flexible area 333 may sag together. Damage to the flexible display 230 may occur according to sagging of the flexible display 230 in the third display area 233 in which the support structure is vulnerable.

The flexible display 230 of FIG. 3C may be supported by the hinge plates 266 and 267, but the flexible display 230 of FIG. 3B may relatively lack a support structure, since the hinge plates 266 and 267 are not disposed on the hinge module 262. A mounting space of the electronic device 101 may be reduced by the disposition of the first FPCB 310 and the second FPCB 320 for a touch input or an input through an external electronic pen on a surface of the flexible display 230. In order to reduce the thickness of the electronic device 101, a structure capable of protecting a display in which the support structure is removed and a protective layer in the display panel is reduced in an area corresponding to the third display area 233 will be described based on drawings to be described later.

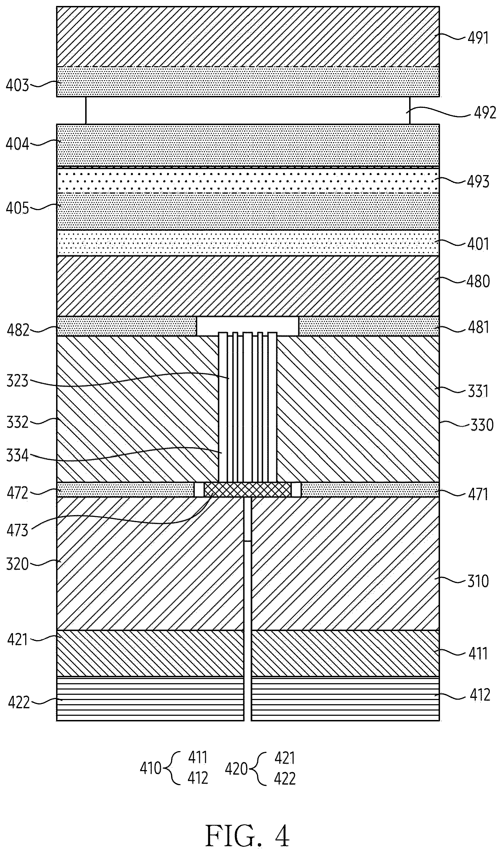

FIG. 4 exemplarily represents a disposition relationship between a display and an input device, according to an embodiment.

Referring to FIG. 4, a flexible display 230 may include a display panel 401, a first layer 491, a window 492, a second layer 493, and a protective layer 480.

According to an embodiment, the window 492 may be disposed on a surface of the display panel 401 facing an outside of an electronic device 101. The window 492 may protect the display panel 401 and transmit light emitted from the display panel 401 to the outside. The window 492 may provide visual information based on transmission of the light. The display 230 may further include adhesive layers 403, 404, and 405 disposed between the first layer 491, the window 492, the second layer 493, and the display panel 401. According to an embodiment, the first layer 491, the window 492, and the second layer 493 may at least partially include a transparent portion. For example, the first layer 491, the window 492, and the second layer 493 may include the transparent portion to transmit light emitted from the display panel 401 to the outside. The first layer 491, the window 492, and/or the second layer 493 may include a polymer material or a glass material. For example, by being formed of the glass material, the window 492 may secure an overall rigidity of the layers disposed on a surface of the display panel 401 facing the outside of the electronic device 101. The window 492 may include an ultra-thin glass (UTG) formed of a thin film glass material. For another example, the window 492 may include the polymer material such as polyimide (PI).

The first layer 491 and/or the second layer 493 may include the thin film formed of the polyimide (PI) and polyethylene terephthalate (PET). According to an embodiment, the first layer 491 may be a layer for protecting the window 492. The first layer 491 may be referred to as a protective film. The first layer 491 may include the polymer material such as the PET. The adhesive layer 403 disposed between the first layer 491 and the window 492 may have lower viscosity or a thinner thickness than other adhesive layers 404 and 405. When it is necessary to replace or remove the first layer 491, in order to remove the first layer 491, the adhesive layer 403 disposed between the first layer 491 and the window 492 may be configured to have lower adhesive force than other adhesive layers 404 and 405.

The second layer 493 may be a layer for protecting the display panel 401. The second layer 493 may include a protective layer or a polarizing layer made of the polymer material such as the PET. In case that a polarizing plate is not included in the display panel 401, the second layer 493 may reinforce the rigidity of the display panel 401.

The display 230 may further include a coating layer (not illustrated) disposed on the first layer 491. The coating layer may have a material having the higher rigidity than the rigidity of the first layer 691 and the second layer 693, and may have scratch-resistance characteristics. The coating layer was described as being disposed on the first layer 491, but may be disposed at various positions. According to an embodiment, the coating layer may include an anti-reflection (AR) coating, a low reflection (LR) coating, a shatter proof (SP) coating, an anti-fingerprint (AF) coating, and the like.

According to an embodiment, the adhesive layers 403, 404, and 405 may be the transparent adhesive layers capable of transmitting light. For example, the adhesive layers 403, 404, and 405 may include a pressure sensitive adhesive (PSA) or an optical clear adhesive (OCA).

According to an embodiment, the display 230 may further include the protective layer 480 disposed on another surface of the display panel 401. According to an embodiment, the protective layer 480 may be disposed on another surface of the display panel 401. For example, the window 492 may be disposed on a surface of the display panel 401, and the protective layer 480 may be disposed on another surface facing the surface of the display panel 401. The protective layer 480 may be a film for protecting the display panel 401. The protective layer 480 may be formed of the polymer material such as the PET. The protective layer 480 may protect another surface of the display panel 401. For example, the protective layer 480 may prevent damage to the display panel 401 by the support plate 330 that is disposed under the display panel 401 and has the rigidity. The support plate 330 may include a first rigid area 331, a second rigid area 332, and a flexible area 333. The first rigid area 331 and the second rigid area 332 may support the display panel 401. For example, the first rigid area 331 may support the first display area 231, and the second rigid area 332 may support the second display area 232. The flexible area 333 may support the third display area 233. The flexible area 333 may include slits 334 parallel to a folding axis f for deformation of the third display area 233. According to an embodiment, the support plate 330 may be attached to the protective layer 480 through adhesive members 481 and 482.

According to an embodiment, the support plate 330 may be in contact with the first FPCB 310 and the second FPCB 320. The first FPCB 310 may be attached to the first rigid area 331 of the support plate 330, and the second FPCB 320 may be attached to the second rigid area 332 of the support plate 330. In the third display area 233, the first FPCB 310 may be disposed under a portion of the flexible area 333, and the second FPCB 320 may be disposed under a remaining portion of the flexible area 333. The electronic device 101 may include an elastic layer 473 between the first FPCB 310 and the portion of the flexible area 333 of the support plate 330 and between the second FPCB 320 and the remaining portion of the flexible area 333 of the support plate 330. The elastic layer 473 may include a thermoplastic polyurethane (TPU), the PET, the PI, or a combination thereof. The elastic layer 473 may protect the first FPCB 310 and the second FPCB 320 by reducing impact due to the support plate 330.

According to an embodiment, the electronic device 101 may further include functional layers 410 and 420 under the first FPCB 310 and the second FPCB 320. The functional layers 410 and 420 may include a magnetic material or a metal layer for shielding. For example, in case that the first FPCB 310 and the second FPCB 320 are electromagnetic induction panels, the functional layers 410 and 420 may include magnetic layers 411 and 421 including the magnetic material for inducing magnetic force generated from the electromagnetic induction panel along the functional layers 410 and 420 in contact with the electromagnetic induction panel. According to an embodiment, the magnetic layers 411 and 412 may be disposed to increase density of a magnetic force line generated from an electromagnetic induction panel.

The functional layers 410 and 420 may include shielding layers 421 and 422 for preventing signals flowing along a conductive pattern in the first FPCB 310 and the second FPCB 320 from being interfered with by an external electrical signal.

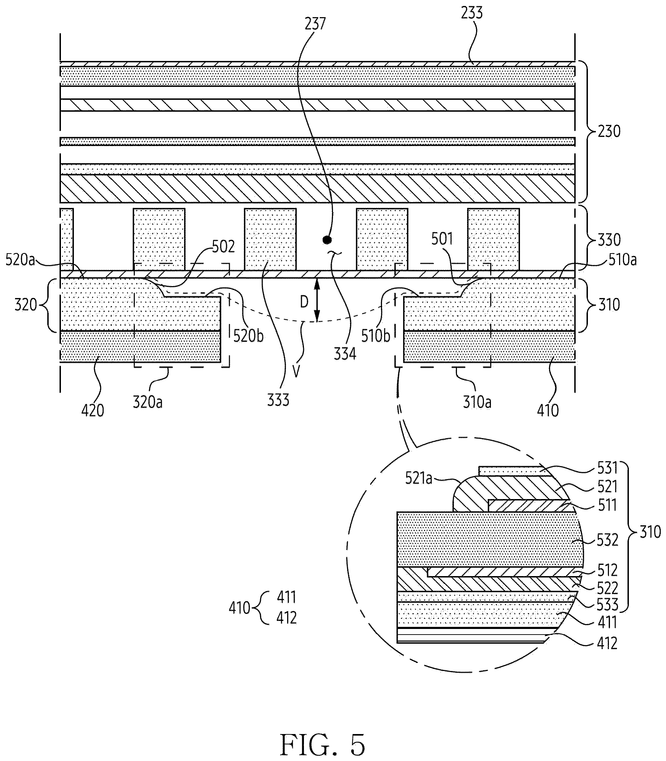

FIG. 5 exemplarily represents a disposition relationship in which a space between an input device and a display disposed under a third display area is spaced apart, according to an embodiment.

Referring to FIG. 5, an electronic device 101 may include a flexible display 230, a support plate 330, a first FPCB 310, a second FPCB 320, and/or functional layers 410 and 420.

According to an embodiment, the flexible display 230 and the support plate 330 may be attached to each other and deformed together. The flexible display 230 and the support plate 330 may be deformed by pressure applied to a third display area 233. A hinge module 262 or hinge plates 266 and 267 are disposed on a rear surface of the third display area 233, but the hinge module 262 and the hinge plates 266 and 267 may include a gap (e.g., the gap g of FIG. 3B or the gap g of FIG. 3C). As the gap g is positioned, the third display area 233 may be relatively vulnerable to the pressure or an impact applied from an outside. As a protective layer of the flexible display 230 becomes thinner or is partially removed due to thinning of the electronic device 101, a structure for supplementing durability of the display area may be required. A first area 310a of the first FPCB 310 may face a second area 320a of the second FPCB 320. When the flexible display 230 is viewed from above, a lateral surface of the first FPCB 310 and a lateral surface of the second FPCB 320 may overlap the third display area 233. The first area 310a of the first FPCB 310 and the second area 320a of the second FPCB 320 may be spaced apart from each other. The electronic device 101 may provide a structure in which the first FPCB 310 and the support plate 330 are spaced apart in the third display area 233 and a structure in which the second FPCB 320 and the support plate 330 are spaced apart in the third display area 233. For example, the first area 310a of the first FPCB 310 may be recessed from a surface 510a facing the support plate 330 to be spaced apart from the support plate 330. For example, the first area 310a of the first FPCB 310 may be recessed from the surface 510a toward a hinge structure (e.g., the hinge structure 260 of FIG. 2C). The first FPCB 310 may include the surface 510a in contact with the support plate 330 and a recessed surface 510b recessed from the surface 510a in the first area 310a. The first FPCB 310 may include a stepped portion 501 between the surface 510a and the recessed surface 510b. Similar to the first FPCB 310, the second area 320a of the second FPCB 320 may be recessed from a surface 520a facing the support plate 330 in order to be spaced apart from the support plate 330. For example, the second FPCB 320 may include the surface 520a in contact with the support plate 330 and a recessed surface 520b recessed from the surface 520a in the second area 320a. The second FPCB 320 may include a stepped portion 502 between the surface 520a and the recessed surface 520b.

According to an embodiment, the first FPCB 310 may include a first non-conductive layer 531, a second non-conductive layer 532, and a third non-conductive layer 533. The first non-conductive layer 531 may be in contact with a surface of the support plate 330. The second non-conductive layer 532 may include a first conductive pattern 511 and a second conductive pattern 512. The second non-conductive layer 532 may include at least one of epoxy or glass fiber. The second non-conductive layer 532 may be referred to as a base in terms that the conductive patterns 511 and 512 are printed on the surface. The second non-conductive layer 532 may include the first conductive pattern 511 disposed in a surface facing the first non-conductive layer 531, and the second conductive pattern 512 disposed in another surface distinct from the surface. The second non-conductive layer 532 may be in contact with the first non-conductive layer 531. The second non-conductive layer 532 may be attached to the first non-conductive layer 531 through a first adhesive layer 521.

According to an embodiment, the second conductive pattern 512 may be disposed on a surface of the second non-conductive layer 532 facing the third non-conductive layer 533. The third non-conductive layer 533 may be in contact with the other surface of the second non-conductive layer 532. The third non-conductive layer 533 may be in contact with the second non-conductive layer 532 through a second adhesive layer 522.

According to an embodiment, the second FPCB 320 has may include the first non-conductive layer 531, the second non-conductive layer 532, and the third non-conductive layer 533, as a similar structure to that of the first FPCB 310.

According to an embodiment, the first FPCB 310 or the second FPCB 320 may include the second conductive pattern 512 among the first conductive pattern 511 and the second conductive pattern 512 in the first area 310a or the second area 320a. The first FPCB 310 or the second FPCB 320 may include the third non-conductive layer 533 among the first non-conductive layer 531 and the third non-conductive layer 533 in the first area 310a or the second area 320a.

The first non-conductive layer 531 may be disposed on a remaining area distinct from the first area 310a or the second area 320a. For example, the first non-conductive layer 531 may form the surface 510a of the first FPCB 310 or the surface 520a of the second FPCB 310. The first non-conductive layer 531 may be cut and removed from the first area 310a or the second area 320a. The first conductive pattern 511 may be disposed in the remaining area distinct from the first area 310a or the second area 320a. For example, the first conductive pattern 511 may be disposed under the surface 510a of the first FPCB 310 or the surface 520a of the second FPCB 320. The first conductive pattern 511 may be cut and removed from the first area 310a. The first adhesive layer 521 may include an inclined surface 521a extending from a boundary of the first non-conductive layer 531 toward a folding axis 237. The second conductive pattern 512, the third non-conductive layer 533, the second adhesive layer 522, and the functional layer 410 disposed under the second non-conductive layer 532 may be formed as a substantially planar surface. The functional layer 410 may include a magnetic layer 411 and a shielding layer 421. The first non-conductive layer 531, the second non-conductive layer 532, the third non-conductive layer 533, the first conductive pattern 511, and the second conductive pattern 512 described above are described based on the first FPCB 310, but the second FPCB 320 may also include the same or similar configuration.

According to an embodiment, the first FPCB 310 may include the stepped portion 501 and the recessed surface 510b, and the second FPCB 320 may include the stepped portion 502 and the recessed surface 520b. In case that the flexible display 230 is deformed by an external impact in the third display area 233, the flexible display 230 may be deformed into a shape V according to a shape of the stepped portion 501 and the recessed surface 510b of the first FPCB 310 and a disposition of the stepped portion 502 and the recessed surface 520b of the second FPCB 320. In case that the first FPCB 310 and the second FPCB 320 do not include the stepped portion, the flexible display 230 may be deformed at a boundary between the first FPCB 310 and the second FPCB 320. Since the first FPCB 310 and the second FPCB 320 including the stepped portion cause deformation over a large extent, when constant force is applied to the third display area, magnitude of the force applied to a unit extent of the flexible display 230 may be reduced. According to an embodiment, the maximum magnitude of the force applied to the flexible display 230 may be reduced, and damage to the flexible display 230 may be reduced.

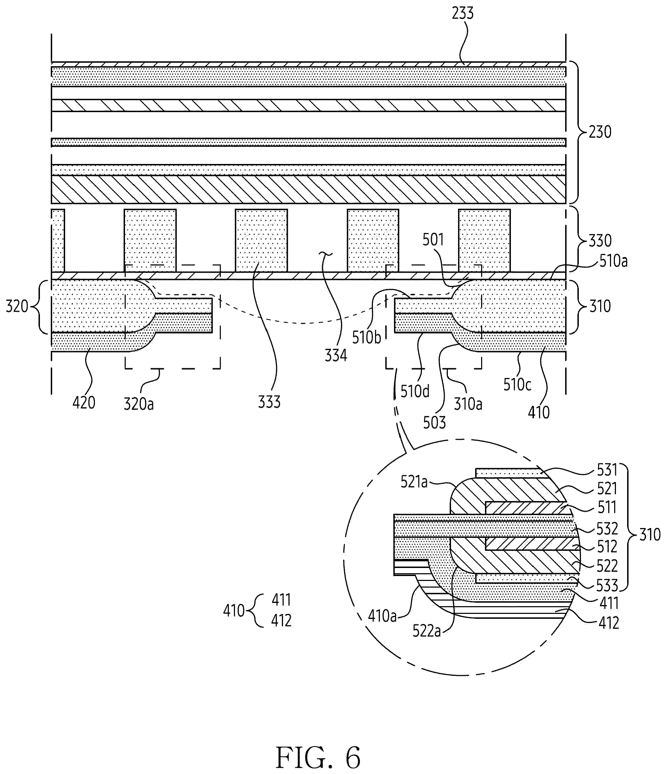

FIG. 6 exemplarily represents a disposition relationship in which a portion of a layer of an input device disposed under a third display area is removed according to an embodiment.

Referring to FIG. 6, an electronic device 101 may include a flexible display 230, a support plate 330, a first FPCB 310, a second FPCB 320, and/or functional layers 410 and 420.

According to an embodiment, the flexible display 230, the support plate 330, the first FPCB 310, the second FPCB 320, and/or the functional layers 410 and 420 may be the same as or similar to the configuration of FIG. 5. In FIG. 6, configuration of the first FPCB 310, the second FPCB 320, and/or the functional layers 410 and 420 which are different from FIG. 5 will be described.

According to an embodiment, the first FPCB 310 or the second FPCB 320 may include a recessed surface recessed from each surface in a first area 310a or a second area 310b. For example, recessed surfaces 510b and 510d may be included in each of both surfaces of the first FPCB 310. For example, the first FPCB 310 may include the recessed surface 510b recessed from a surface 510a toward the functional layer 410 and the recessed surface 510d recessed from another surface 510c facing the surface 510a toward the support plate 330. A thickness of the first FPCB 310 may be thinner than another area in the first area 310a.

According to an embodiment, the electronic device 101 may provide a structure in which the first FPCB 310 and the support plate 330 are spaced apart in the third display area 233 and a structure in which the second FPCB 320 and the support plate 330 are spaced apart in the third display area 233. The first area 310a of the first FPCB 310 may be recessed from the surface 510a toward a hinge structure (e.g., the hinge structure 260 of FIG. 2C). In the first area 310a, the first FPCB 310 may include the surface 510a in contact with the support plate 330 and the recessed surface 510b recessed from the surface 510a. The first FPCB 310 may include a stepped portion 501 between the surface 510a and the recessed surface 510b.

According to an embodiment, in each of the first area 310a and the second area 310b, the first FPCB 310 or the second FPCB 320 may be recessed from another surface 510c facing the hinge structure 260 toward the support plate 330. For example, the first FPCB 310 and the functional layer 410 may further include a stepped portion 503 corresponding to the stepped portion 501 in the third display area 233. For example, the first area 310a of the first FPCB 310 and the functional layer 410 may be recessed from another surface 501c facing the surface 510a toward the support plate 330 in order to move away from a hinge cover 265 or the hinge structure 260. The first FPCB 310 may include the recessed surface 510d recessed from another surface 510b and the other surface 510c in the first area 310a. The first FPCB 310 may include the stepped portion 503 between the other surface 510c and the recessed surface 510d. Similar to the first FPCB 310, the second area 320a of the second FPCB 320 may include the same as or similar configuration as the stepped portion 501 and the stepped portion 503.

According to an embodiment, each of the first FPCB 310 and the second FPCB 320 may include a second non-conductive layer 532 including a first conductive pattern 511 disposed toward the support plate 330 and a second conductive pattern 512 facing the hinge structure 260, and a third non-conductive layer 533 in contact with a surface of the second non-conductive layer 532 in which the second conductive pattern 512 is disposed. Each of the first FPCB 310 and/or the second FPCB 320 may include the functional layer 410, which is functional layers disposed in a surface of the second non-conductive layer 532 and the third non-conductive layer 533, facing the hinge structure 260.

According to an embodiment, in the first area 310a or the second area 320a, the first FPCB 310 or the second FPCB 320 may include the second conductive pattern 512 among the first conductive pattern 511 and the second conductive pattern 512. In the first area 310a or the second area 320a, the first FPCB 310 or the second FPCB 320 may include the second non-conductive layer 532 among the first non-conductive layer 531, the second non-conductive layer 532, and the third non-conductive layer 533.

According to an embodiment, the first non-conductive layer 531 and the third non-conductive layer 533 may be disposed on a remaining area distinct from the first area 310a or the second area 320a. For example, the first non-conductive layer 531 may form the surface 510a of the first FPCB 310 or a surface 520a of the second FPCB 310. The first non-conductive layer 531 may be cut and removed from the first area 310a or the second area 320a. The third non-conductive layer 533 may be removed from the first area 310a or the second area 320a. The other surface 510c and the recessed surface 510d of the first FPCB 310 may be formed by the functional layer 410. For example, the functional layer 410 may cover the third non-conductive layer 533. The functional layer 410 may extend along the third non-conductive layer 533. The functional layer 410 may form an inclined surface 410a from a periphery of the third non-conductive layer 533. The functional layer 410 may form the recessed surface 510d in the first area 310a from which the third non-conductive layer 533 is removed. The functional layer 410 may include a magnetic layer 411 and a shielding layer 412. The magnetic layer 411 may be disposed along the surface of the third non-conductive layer 533 and a second adhesive layer 522. The shielding layer 412 may be disposed along the magnetic layer 411.

According to an embodiment, the first conductive pattern 511 may be disposed in a remaining area distinct from the first area 310a or the second area 320a. For example, the first conductive pattern 511 may be disposed under the surface 510a of the first FPCB 310 or the surface 520a of the second FPCB 320. The first conductive pattern 511 may be cut and removed from the first area 310a. The first adhesive layer 521 may include an inclined surface 521a extending from a boundary of the first non-conductive layer 531 toward a folding axis 237.

According to an embodiment, the second conductive pattern 512 may be disposed in the remaining area distinct from the first area 310a or the second area 320a. For example, the second conductive pattern 512 may be disposed on another surface 510b of the first FPCB 310 or another surface 520b of the second FPCB 320. The second conductive pattern 512 may be cut and removed from the first area 310a. The second adhesive layer 522 may include an inclined surface 522a extending from a boundary of the third non-conductive layer 533 toward the folding axis 237.

According to the above-described embodiment, the first FPCB 310 and the second FPCB 320 may include a structure that separates the support plate 330 from the first FPCB 310 and the second FPCB 320 in order to reduce force applied per unit extent of the flexible display 230 in case that the flexible display 230 is deformed. The first FPCB 310 and the second FPCB 320 may form an additional recessed surface 510d by removing the second conductive pattern 512 and the third non-conductive layer 533. The first FPCB 310 and the second FPCB 320 may secure a gap in a direction (e.g., a direction facing the hinge structure) facing an inside of the electronic device 101 by removing a portion of a surface facing the inside of the electronic device 101. When the flexible display 230 sags, damage may be reduced by preventing contact with external structures through the gap.

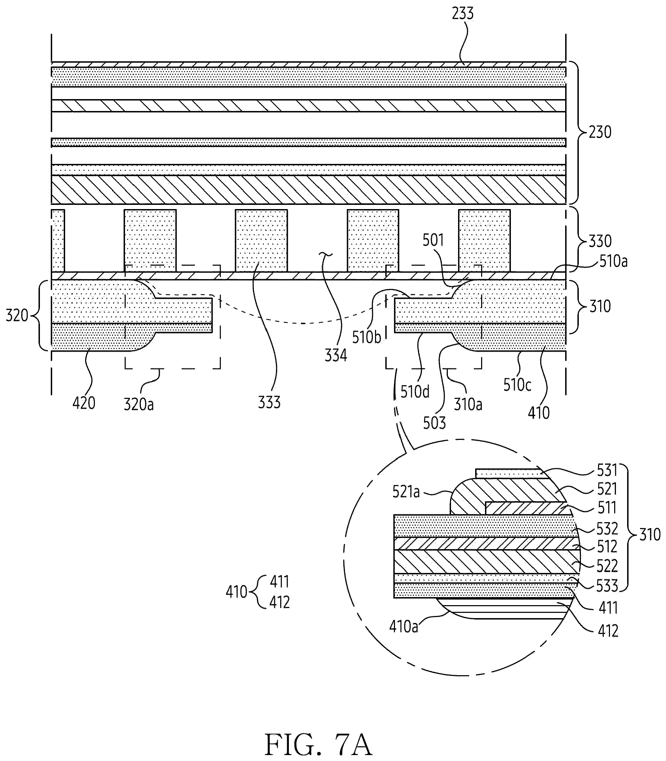

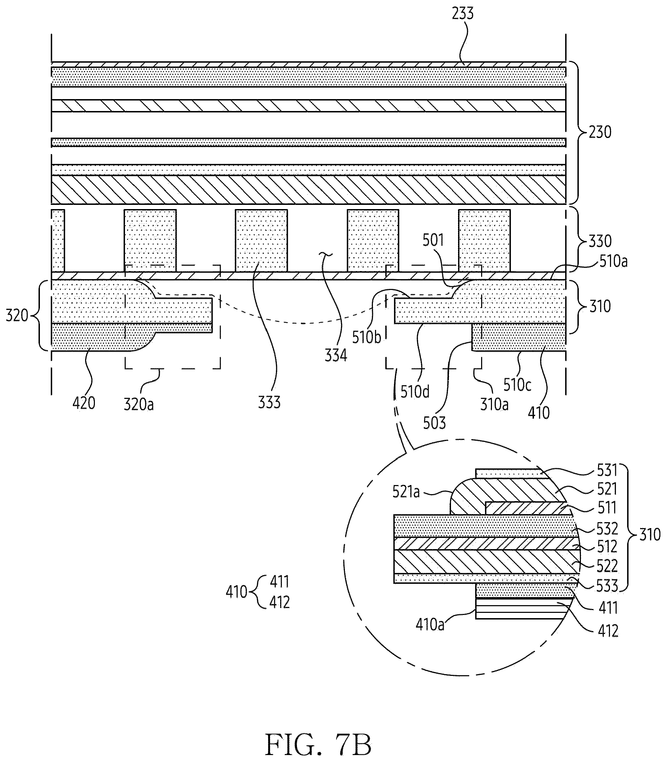

FIGS. 7A and 7B exemplarily represent a disposition relationship in which a portion of a functional layer in contact with an input device disposed under a third display area is removed, according to an embodiment.

Referring to FIGS. 7A and 7B, an electronic device 101 may include a flexible display 230, a support plate 330, a first FPCB 310, a second FPCB 320, and/or functional layers 410 and 420.

According to an embodiment, the flexible display 230, the support plate 330, the first FPCB 310, the second FPCB 320, and/or the functional layers 410 and 420 may be the same as or similar to the configuration of FIGS. 5 and/or 6. In FIG. 7A, configuration of the first FPCB 310, the second FPCB 320, and/or the functional layers 410 and 420 which are different from FIGS. 5 and 6 will be described.

According to an embodiment, the first FPCB 310 or the second FPCB 320 may be recessed from each surface in a first area 310a or a second area 310b. For example, recessed surfaces 510b and 510d may be included in each of both surfaces of the first FPCB 310. For example, the first FPCB 310 may include the recessed surface 510b recessed from the surface 510a toward the functional layer 410 and the recessed surface 510d recessed from another surface 510c facing the surface 510a toward the support plate 330. A thickness of the first FPCB 310 may be thinner than another area in the first area 310a.

In FIGS. 7A and 7B, the configuration of the third non-conductive layer 533, the second conductive pattern 512, and the functional layer 410 of FIG. 6 may be different.

According to an embodiment, each of the first FPCB 310 and the second FPCB 320 may include a second non-conductive layer 532 including a first conductive pattern 511 disposed toward the support plate 330 and the second conductive pattern 512 facing the hinge structure 260, and a third non-conductive layer 533 in contact with a surface of the second non-conductive layer 532 in which the second conductive pattern 512 is disposed. Each of the first FPCB 310 and/or the second FPCB 320 may include the functional layer 410, which is functional layers disposed in a surface of the second non-conductive layer 532 and the third non-conductive layer 533, facing the hinge structure 260.

The second conductive pattern 512 may extend along the surface of the second non-conductive layer 532. The second conductive pattern 512 may extend from a stepped portion 503 into the first area 310a. The third non-conductive layer 533 may be disposed to cover the second conductive pattern 512. A portion of the third non-conductive layer 533 may be disposed in the first area 310a, covering the second conductive pattern 512. The third non-conductive layer 533 may extend substantially parallel to the second non-conductive layer 532. The third non-conductive layer 533 may form substantially a plane.

The functional layer 410 may be partially deleted in the first area 310a. For example, the functional layer 410 may be partially deleted in the first area 310a in which the first FPCB 310 faces the second FPCB 320, and form the recessed surface 510d and the stepped portion 503. For example, the functional layer 410 may have an inclined surface 410a corresponding to the stepped portion 503 in the first area 310a.

Referring to FIG. 7A, a shielding layer 412 of the functional layer 410 may be deleted in the first area 310a. For example, in the first area 310a, a portion of the shielding layer 412 may be cut and removed. A removed surface of the shielding layer 412 may be the stepped portion 503. The stepped portion 503 is indicated to have the inclined surface 410a, but is not limited thereto. The stepped portion 503 may be substantially perpendicular to the other surface 510c or the recessed surface 510d.

Referring to FIG. 7B, both the magnetic layer 411 and the shielding layer 412 of the functional layer 410 may be removed in the first area 310a. A portion of the magnetic layer 411 and the shielding layer 412 may be cut and removed. The stepped portion 503 may be formed at a boundary between the magnetic layer 411 and the shielding layer 412 or in a cut area of the magnetic layer 411 and the shielding layer 412. A cut surface of the magnetic layer 411 and the shielding layer 412 may be substantially perpendicular to the other surface 510c of the first FPCB 310.

According to the above-described embodiment, the first FPCB 310 and the second FPCB 320 may include a structure that separates the support plate 330 from the first FPCB 310 and the second FPCB 320 in order to reduce force applied per unit extent of the flexible display 230 in case that the flexible display 230 is deformed. The first FPCB 310 and the second FPCB 320 may form the additional recessed surface 510d and the stepped portion 503 by removing the functional layer 410. The first FPCB 310 and the second FPCB 320 may secure a gap in a direction (e.g., a direction facing the hinge structure) facing an inside of the electronic device 101 by removing the portion of the surface facing the inside of the electronic device 101. When the flexible display 230 sags, damage may be reduced by preventing contact with external structures through the gap.

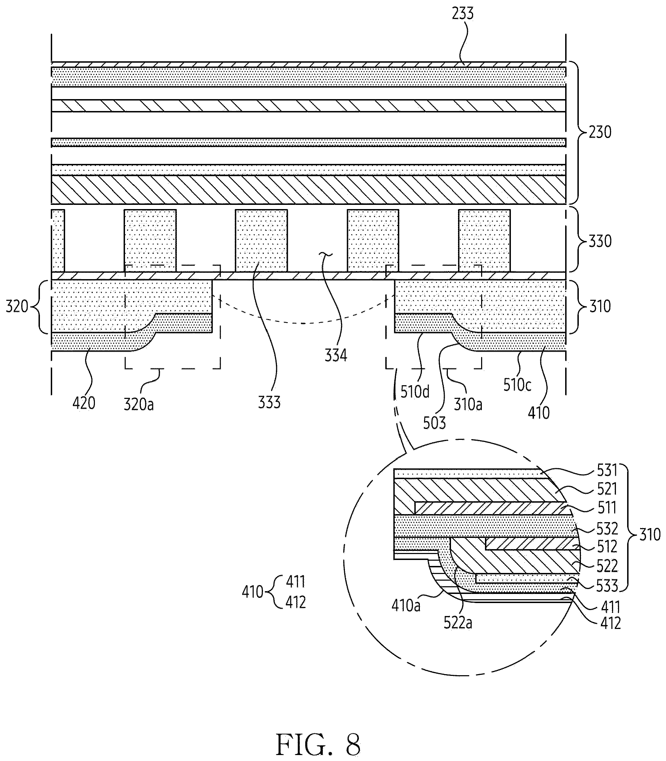

FIG. 8 exemplarily represents a disposition relationship in which an input device and a display disposed under a third display area are attached and a portion of the input device is removed, according to an embodiment.

Referring to FIG. 8, an electronic device 101 may include a flexible display 230, a support plate 330, a first FPCB 310, a second FPCB 320, and/or functional layers 410 and 420.

According to an embodiment, the flexible display 230, the support plate 330, the first FPCB 310, the second FPCB 320, and/or the functional layers 410, 420 may be the same as or similar to the configuration of FIGS. 5, 6, and/or 7. In FIG. 8, configuration of the first FPCB 310, the second FPCB 320, and/or the functional layers 410 and 420 which are different from FIGS. 5, 6, and 7 will be described.

According to an embodiment, the electronic device 101 may include a recessed portion that forms a gap that separates the first FPCB 310 and the second FPCB 320 from other instruments of the electronic device 101 in a third display area 233. For example, a first area 310a of the first FPCB 310 may be recessed from another surface 510c toward the support plate 330 in order to be spaced apart from the instruments (e.g., a hinge structure 260) in the electronic device 101. For example, the first area 310a of the first FPCB 310 may be recessed from the other surface 510c toward the support plate 330. In the first area 310a, the first FPCB 310 may include the other surface 510c (e.g., a surface opposite to a surface 510a in contact with the support plate 330) facing the inside of the electronic device 101 and a recessed surface 510d recessed from the other surface 510c. The first FPCB 310 may include a stepped portion 503 between the other surface 510c and the recessed surface 510d. Similar to the first FPCB 310, a second area 320a of the second FPCB 320 may be recessed from another surface 520c in a direction toward the support plate 330 in order to be spaced apart from the instruments of the inside of the electronic device 101. For example, in the second area 320a, the second FPCB 320 may include the other surface 520c facing the inside of the electronic device and a recessed surface 520d recessed from the other surface 520c. The second FPCB 320 may include a stepped portion 504 between the other surface 520c and the recessed surface 520d.

According to an embodiment, the first FPCB 310 may include a first non-conductive layer 531, a second non-conductive layer 532, and a third non-conductive layer 533. The first non-conductive layer 531 may be in contact with a surface of the support plate 330. The second non-conductive layer 532 may include a first conductive pattern 511 and a second conductive pattern 512. The second non-conductive layer 532 may include at least one of epoxy or glass fiber. The second non-conductive layer 532 may be referred to as a base in terms that the conductive patterns 511 and 512 are printed on the surface. The second non-conductive layer 532 may include the first conductive pattern 511 disposed in a surface facing the first non-conductive layer 531, and the second conductive pattern 512 disposed in another surface distinct from the surface. The second non-conductive layer 532 may be in contact with the first non-conductive layer 531. The second non-conductive layer 532 may be attached to the first non-conductive layer 531 through a first adhesive layer 521.

According to an embodiment, the second conductive pattern 512 may be disposed on a surface of the second non-conductive layer 532 facing the third non-conductive layer 533. The third non-conductive layer 533 may be in contact with the other surface of the second non-conductive layer 532. The third non-conductive layer 533 may be in contact with the second non-conductive layer 532 through a second adhesive layer 522.

According to an embodiment, the second FPCB 320 may include the first non-conductive layer 531, the second non-conductive layer 532, and the third non-conductive layer 533, as a similar structure to that of the first FPCB 310.

According to an embodiment, the first FPCB 310 or the second FPCB 320 may include the first conductive pattern 511 among the first conductive pattern 511 and the second conductive pattern 512 in the first area 310a or the second area 320a. The first FPCB 310 or the second FPCB 320 may include the first non-conductive layer 531 among the first non-conductive layer 531 and the third non-conductive layer 533 in the first area 310a or the second area 320a.

The third non-conductive layer 533 may be disposed on a remaining area distinct from the first area 310a or the second area 320a. For example, the third non-conductive layer 533 may face the other surface 510c of the first FPCB 310 or the other surface 520c of the second FPCB 310. The third non-conductive layer 533 may be cut and removed from the first area 310a or the second area 320a. The second conductive pattern 512 may be disposed in the remaining area distinct from the first area 310a or the second area 320a. For example, the second conductive pattern 512 may be disposed on the other surface 510c of the first FPCB 310 or the other surface 520c of the second FPCB 320. The second conductive pattern 512 may be disposed on the surface of the second non-conductive layer 532 facing the third non-conductive layer 533. The second conductive pattern 512 may be cut and removed from the first area 310a. The second adhesive layer 522 may include an inclined surface 522a extending from a boundary of the third non-conductive layer 533 toward a folding axis 237. The functional layer 410 may include a magnetic layer 411 and a shielding layer 421. The magnetic layer 411 may be disposed along the surface of the third non-conductive layer 533 and the second adhesive layer 522. The shielding layer 412 may be disposed along the magnetic layer 411. The shielding layer 412 may include an inclined surface 410a corresponding to the inclined surface 522a of the second adhesive layer 522. The first non-conductive layer 531, the second non-conductive layer 532, the third non-conductive layer 533, the first conductive pattern 511, and the second conductive pattern 512 described above are described based on the first FPCB 310, but the second FPCB 320 may also have the same or similar configuration.

According to the above-described embodiment, the first FPCB 310 and the second FPCB 320 may include a structure that separates the support plate 330 from the first FPCB 310 and the second FPCB 320 in order to reduce force applied per unit extent of the flexible display 230 in case that the flexible display 230 is deformed. The first FPCB 310 and the second FPCB 320 may form the additional recessed surface 510d and the stepped portion 503 by removing the functional layer 410. The first FPCB 310 and the second FPCB 320 may secure a gap in a direction (e.g., a direction facing the hinge structure) facing the inside of the electronic device 101 by removing a portion of the surface facing the inside of the electronic device 101. When the flexible display 230 sags, damage may be reduced by preventing contact with external structures through the gap.

According to the above-described embodiment, the first FPCB 310 and the second FPCB 320 may form the additional recessed surface 510d and the stepped portion 503 by removing the second conductive pattern 512 and the third non-conductive layer 533. The first FPCB 310 and the second FPCB 320 may secure the gap in the direction (e.g., the direction facing the hinge structure) facing the inside of the electronic device 101 by removing the portion of the surface facing the inside of the electronic device 101. When the flexible display 230 sags, damage may be reduced by preventing contact with the external structures through the gap.

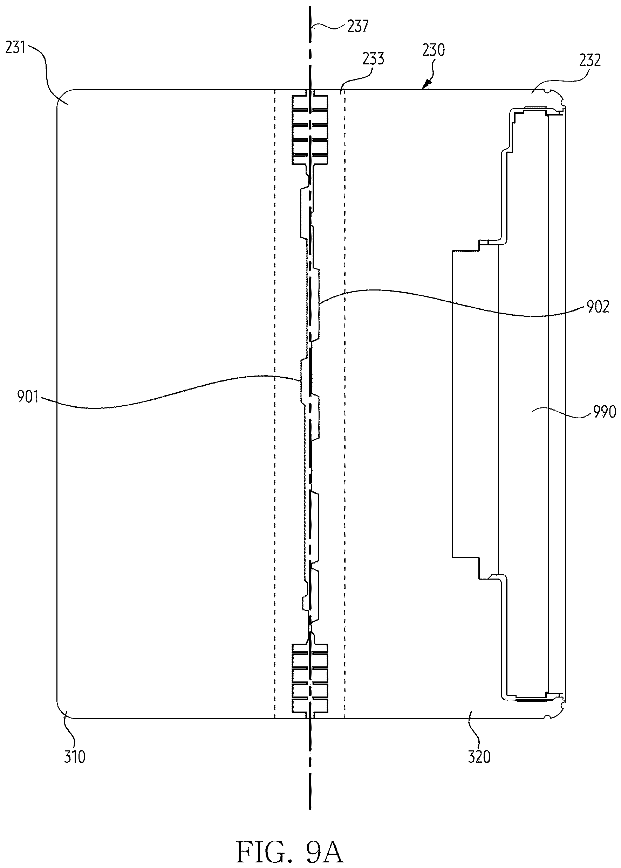

FIG. 9A represents a disposition of an exemplary input device, according to an embodiment.

Referring to FIG. 9A, a first FPCB 310 and a second FPCB 320 may be an electromagnetic induction panel attached to a rear surface of a display 230. The first FPCB 310 and the second FPCB 320 may face each other in a third display area 233. The first FPCB 310 may be disposed under a first display area 231 and a portion of the third display area 233. The second FPCB 320 is disposed under a second display area 232 and another portion of the third display area 233.

According to an embodiment, the first FPCB 310 may be spaced apart from the second FPCB 320 each other at the rear surface of the display 230 in the third display area 233. A lateral surface of the first FPCB 310 facing the second FPCB 320 may be spaced apart from the second FPCB 320, and a lateral surface of the second FPCB 320 facing the first FPCB 310 may be spaced apart from the first FPCB 310. The lateral surface of the first FPCB 310 and the lateral surface of the second FPCB 320 may be disposed in the third display area.

According to an embodiment, the first FPCB 310 may include first protrusions 901 facing the lateral surface of the second FPCB 320 in the third display area 233. For example, the first protrusions 901 may protrude in a direction toward the lateral surface of the second FPCB 320 in a first area (the first area 310a of FIG. 5).

According to an embodiment, the second FPCB 320 may include second protrusions 902 facing the lateral surface of the first FPCB 310 in the third display area 233. For example, the second protrusions 902 may protrude in a direction toward the lateral surface of the first FPCB 310 in a second area (the second area 320a of FIG. 5).

According to an embodiment, the first protrusions may be spaced apart from each other along a folding axis 237. The second protrusions 902 may be spaced apart from each other along the folding axis 237. The first protrusions 901 may be asymmetrical with the second protrusions 902 with respect to the folding axis 237. For example, the first protrusions 901 may be symmetrical with the second protrusions 902 in a partial area. The first protrusions 901 may be asymmetrical with the second protrusions 902 in another area distinct from the partial area.

A disposition of the first protrusions 901 and the second protrusions 902 may be determined according to the rear surface of the flexible display 230, the disposition, a shape, or a structure of an instrument that the first FPCB 310 or the second FPCB 320 faces.

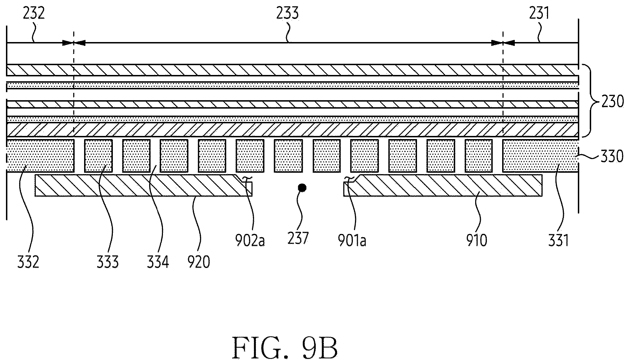

FIG. 9B represents a disposition of an exemplary input device, according to an embodiment.

Referring to FIG. 9B, an electronic device 101 may include a flexible display 230, a support plate 330 supporting the flexible display 230, and a first FPCB 910 and a second FPCB 920 in contact with the support plate 330. The support plate 330 may include a first rigid area 331 corresponding to a first display area 231, a second rigid area 332 corresponding to a second display area 232, and a flexible area 333 corresponding to a third display area 233 of the flexible display 230. The flexible area 333 may include slits 334 parallel to a folding axis 237 to be deformed together with the third display area 233.

According to an embodiment, the first FPCB 910 may be disposed under a portion of the first display area 231 and a portion of the third display area 233. The second FPCB 920 may be disposed under a portion of the second display area 232 and another portion of the third display area 233. Different from the FPCBs 310 and 320 of FIG. 9A, the first FPCB 910 and the second FPCB 920 may be disposed under a portion of the display area of the display 230. Similar to the FPCBs 310 and 320 of FIG. 9A, the first FPCB 910 and the second FPCB 920 may be spaced apart from each other with respect to the folding axis 237.

According to an embodiment, the first FPCB 910 may include a recessed portion 901a to separate the support plate 330 from a portion of the first FPCB 910 in an area facing the second FPCB 920. The second FPCB 920 may include a recessed portion 902a to separate the support plate 330 from a portion of the second FPCB 920 in an area facing the first FPCB 910.

The first FPCB 910 and the second FPCB 920 described above may be a pressure sensor for a user to obtain data related to force applied to the first FPCB 910 and the second FPCB 920. The first FPCB 910 and the second FPCB 920 may be not only the pressure sensor but also a sensor for obtaining data related to access of the user. However, the first FPCB 910 and the second FPCB 920 are not limited thereto, and may function as various types of sensors.

According to an embodiment described above, an electronic device (e.g., the electronic device 101 of FIG. 2C) may include a first housing (e.g., the first housing 210 of FIG. 2C) having a first surface facing a first direction, a second housing (e.g., the second housing 220 of FIG. 2C) including a second surface facing the first direction, a hinge structure (e.g., the hinge structure 260 of FIG. 2C) configured to provide an unfolding state in which the first surface and the second surface face the same direction or a folding state in which the first surface and the second surface face each other, by rotatably coupling the first housing and the second housing with respect to a folding axis, a flexible display (e.g., the flexible display 230 of FIG. 2C) disposed on the first housing and the second housing across the folding axis, a first FPCB (e.g., the first FPCB 310 of FIG. 3B) disposed on the first housing and the hinge structure, a second FPCB (e.g., the second FPCB 320 of FIG. 3B) disposed on the second housing and the hinge structure and spaced apart from the first FPCB, and a support plate (e.g., the support plate 330 of FIG. 3B) disposed between the flexible display and the first FPCB and disposed between the flexible display and the second FPCB. Each of a first area (e.g., the first area 310a of FIG. 4) of the first FPCB facing a lateral surface of the second FPCB and a second area (e.g., the second area 310b of FIG. 4) of the second FPCB facing a lateral surface of the first FPCB may be recessed from a surface facing the support plate toward the hinge structure to be spaced apart from the support plate.

According to an embodiment described above, since a first FPCB and a second FPCB include a recessed portion, a third display area of a flexible display or a flexible area of a support plate may be spaced apart from the first FPCB or the second FPCB. Based on the separation, the flexible display and the support plate may reduce magnitude of force applied to a unit extent by distributing a force applied to the third display area in a wide extent. According to the reduced magnitude of force, damage to the flexible display 230 may be reduced. The embodiment mentioned above may have various effects including the effect mentioned above.

According to an embodiment, the folding axis may be positioned between the first FPCB and the second FPCB. According to an embodiment, the support plate may be exposed to the hinge structure through a gap between the first FPCB and the second FPCB.

According to an embodiment, each of the first FPCB and the second FPCB may include a non-conductive layer (e.g., the first non-conductive layer 531, the second non-conductive layer 532, the third non-conductive layer 533 of FIG. 8), and functional layers (e.g., the functional layers 410 and 420 of FIG. 8). According to an embodiment, the non-conductive layer may include conductive patterns (e.g., the first conductive pattern 511 and the second conductive pattern 512 of FIG. 8) disposed toward the support plate. The functional layers may be disposed on a surface of the non-conductive layer toward the hinge structure. According to an embodiment, a portion of the first area and the second area that is recessed toward the hinge structure may only include the non-conductive layer. Another portion distinct from the portion of the first area and the second area may include the non-conductive layer and the functional layer.

According to an embodiment described above, when a flexible display is deformed toward a hinge structure or a gap between a hinge plate, a first FPCB and a second FPCB may prevent damage to the flexible display by securing a deformation space. The embodiment mentioned above may have various effects including the above-mentioned effect.

According to an embodiment, the first FPCB may include first protrusions (e.g., the first protrusions 901 of FIG. 9A) facing the lateral surface of the second FPCB, in the first area, and the second FPCB may include second protrusions (e.g., the second protrusions 902 of FIG. 9A) facing the lateral surface of the first FPCB, in the second area.

According to an embodiment, the first protrusions may be spaced apart from each other. The first protrusions may be asymmetrical with the second protrusions with respect to the folding axis.

According to an embodiment described above, since FPCBs include protrusions asymmetrical to each other, a deformable area may be adjusted according to a structure of a hinge module or a hinge plate. In an area in which damage of a flexible display is high, the amount of deformation in a height direction of the flexible display may be increased by disposing the protrusions. The embodiment mentioned above may have various effects including the effect mentioned above.

According to an embodiment, each of the first area and the second area may be recessed from another surface facing the hinge structure toward the support plate.

According to an embodiment, each of the first FPCB and the second FPCB may include a non-conductive layer (e.g., the first non-conductive layer 531, the second non-conductive layer 532, or the third non-conductive layer 533 of FIG. 5) including conductive patterns disposed toward the support plate, and functional layers (e.g., the functional layer 410 of FIG. 5) disposed on a surface of the non-conductive layer toward the hinge structure. According to an embodiment, a portion of the first area and the second area that is recessed toward the support plate may only include the non-conductive layer, and another portion distinct from the portion of the first area and the second area may include the non-conductive layer and the functional layer.

According to an embodiment described above, since a first FPCB and a second FPCB include a recessed portion, a third display area of a flexible display or a flexible area of a support plate may be spaced apart from the first FPCB or the second FPCB. Based on the separation, the flexible display and the support plate may reduce magnitude of force applied to a unit extent by distributing the force applied to the third display area in a wide extent. According to the reduced magnitude of force, damage to the flexible display 230 may be reduced. The embodiment mentioned above may have various effects including the effect mentioned above.

According to an embodiment, the flexible display may include a first display area (e.g., the first display area 231 of FIG. 2A) disposed on the first surface, a second display area (e.g., the second display area 232 of FIG. 2A) disposed on the second surface, and a third display area (e.g., the third display area 233 of FIG. 2A) disposed between the first display area and the second display area. According to an embodiment, the first FPCB and the second FPCB may include an electromagnetic induction panel configured to receive an input signal through electromagnetic interaction with an external electronic device. According to an embodiment, the first FPCB may be disposed under the first display area and a portion of the third display area. According to an embodiment, the second FPCB may be disposed under the second display area and another portion of the third display area.

According to an embodiment, each of the first FPCB and the second FPCB may include a first non-conductive layer (e.g., the first non-conductive layer 531 of FIG. 5) in contact with a surface of the support plate, a second non-conductive layer (e.g., the second non-conductive layer 532 of FIG. 5) in contact with another surface of the first non-conductive layer, and including a first conductive pattern disposed on a surface facing the first non-conductive layer and a second conductive pattern disposed on another surface, a third non-conductive layer (e.g., the third non-conductive layer 533 of FIG. 5) in contact with another surface of the second non-conductive layer, a first adhesive layer (e.g., the first adhesive layer 521 of FIG. 5) disposed between the first non-conductive layer and the second non-conductive layer, and a second adhesive layer (e.g., the second adhesive layer 522 of FIG. 5) disposed between the second non-conductive layer and the third non-conductive layer. Each of the first FPCB and the second FPCB may include the first conductive pattern among the first conductive pattern and the second conductive pattern, in the first area or the second area. According to an embodiment, the first non-conductive layer may be disposed on a remaining area distinct from the first area or the second area. According to an embodiment, the first adhesive layer may include an inclined surface (e.g., the inclined surface 521a) extending from a boundary of the first non-conductive layer toward the folding axis.

According to an embodiment, the second non-conductive layer may include at least one of epoxy or glass fiber.

According to an embodiment described above, since a first FPCB and a second FPCB include a recessed portion, a third display area of a flexible display or a flexible area of a support plate may be spaced apart from the first FPCB or the second FPCB through the inclined surface. The embodiment mentioned above may have various effects including the effect mentioned above.

According to an embodiment, the first FPCB and the second FPCB may be configured to identify an external object approaching or contacting on the third display area of the flexible display corresponding to the first FPCB and the second FPCB.

According to an embodiment, the support plate may include carbon fiber reinforced plastic (CFRP) or metal.

According to an embodiment, the support plate may include a first rigid area corresponding to the first display area, a second rigid area corresponding to the second display area, and a flexible area disposed between the first rigid area and the second rigid area. The flexible area may include a plurality of slits.

According to an embodiment, the flexible display may include a flexible display panel and a protection layer disposed between the flexible display panel and the support plate and across the third area.

According to an embodiment, the protection layer may be attached to the support plate through the adhesive layer, and the adhesive layer may be disposed on the support plate corresponding to the first display area and the second display area.

According to an embodiment, when the flexible display is viewed from above, the lateral surface of the first FPCB and the lateral surface of the second FPCB may overlap the third display area.

According to an embodiment, an electronic device (e.g., the electronic device 101 of FIG. 2C) may include a first housing (e.g., the first housing 210 of FIG. 2C) having a first surface facing a first direction, a second housing (e.g., the second housing 220 of FIG. 2C) including a second surface facing the first direction, a hinge structure (e.g., the hinge structure 260 of FIG. 2C) configured to provide an unfolding state in which the first surface and the second surface face the same direction or a folding state in which the first surface and the second surface face each other, by rotatably coupling the first housing and the second housing with respect to a folding axis (e.g., the folding axis 237 of FIG. 2C), a flexible display (e.g., the flexible display 230 of FIG. 2C) disposed on the first housing and the second housing across the folding axis, a first FPCB (e.g., the first FPCB 310 of FIG. 3B) disposed on the first housing and the hinge structure, a second FPCB (e.g., the second FPCB 320 of FIG. 3B) disposed on the second housing and the hinge structure and spaced apart from the first FPCB, and a support plate (e.g., the support plate 330 of FIG. 3B) disposed between the flexible display and the first FPCB and disposed between the flexible display and the second FPCB. A first area (e.g., the first area 310a of FIG. 4) of the first FPCB facing a lateral surface of the second FPCB may be thinner than a second area distinct from the first area of the first FPCB. According to an embodiment, a third area (e.g., the second area 320a of FIG. 4) of the second FPCB facing a lateral surface of the first FPCB may be thinner than a fourth area distinct from the third area of the second FPCB.

According to an embodiment described above, since a first FPCB and a second FPCB include a recessed portion, a third display area of a flexible display or a flexible area of a support plate may be spaced apart from the first FPCB or the second FPCB. Based on the separation, the flexible display and the support plate may reduce magnitude of force applied to a unit extent by distributing the force applied to the third display area in a wide extent. According to the reduced magnitude of force, damage to the flexible display 230 may be reduced. The embodiment mentioned above may have various effects including the effect mentioned above.

According to an embodiment, each of the first area and the third area may be spaced apart from the support plate. Each of the second area and the fourth area may contact the support plate.

According to an embodiment, a distance from a surface of the first FPCB facing the hinge structure to the hinge structure in the first area may be longer than a distance from a surface of the second FPCB facing the hinge structure to the hinge structure in the second area.

According to an embodiment, each of the first FPCB and the second FPCB may contact the support plate.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," or "connected with" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between a case in which data is semi-permanently stored in the storage medium and a case in which the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. An electronic device (101) comprising:
a first housing (210);
a second housing (220);
a hinge structure (260) configured to rotatably couple the first housing (210) and the second housing (220) with respect to a folding axis (237);
a flexible display (230) including:
a display panel (401), and
a support plate (330) disposed under the display panel (401) for supporting the display panel (401), wherein the support plate (330) includes a flexible area (333) including a plurality of slits (334) for deformation of a portion of the flexible display (230);
a first flexible printed circuit board, FPCB, (310) disposed on the first housing (210) and the hinge structure (260); and
a second FPCB (320) disposed on the second housing (220) and the hinge structure (260) and spaced apart from the first FPCB (310); wherein a gap (g) between the first FPCB (310) and the second FPCB (320) is defined under the flexible area (333) of the support plate (330), and
wherein each of a first area (310a) of the first FPCB (310), disposed under the flexible area (333), facing a lateral surface of the second FPCB (320) and a second area (320a) of the second FPCB (320), disposed under the flexible area (333), facing a lateral surface of the first FPCB (310) is recessed from a surface facing the support plate (330) toward the hinge structure (260) to be spaced apart from the support plate (330).

2. The electronic device (101) of claim 1,
wherein the folding axis (237) is positioned between the first FPCB (310) and the second FPCB (320), and
wherein the support plate (330) faces the hinge structure (260) through the gap (g) between the first FPCB (310) and the second FPCB (320).

3. The electronic device (101) of any one of the preceding claims,
wherein each of the first FPCB (310) and the second FPCB (320) includes:
a non-conductive layer (531, 532, 533) including conductive patterns (511, 512) disposed toward the support plate (330), and
functional layers disposed on a surface of the non-conductive layer (531, 532, 533) toward the hinge structure (260),
wherein a portion of the first area (310a) and the second area (320a) that is recessed toward the hinge structure (260) only includes the non-conductive layer (531, 532, 533), and
wherein another portion distinct from the portion of the first area (310a) and the second area (320a) includes the non-conductive layer (531, 532, 533) and the functional layer.

4. The electronic device (101) of any one of the preceding claims,
wherein the first FPCB (310) includes first protrusions (901) facing the lateral surface of the second FPCB (320), in the first area (310a), and
wherein the second FPCB (320) includes second protrusions (902) facing the lateral surface of the first FPCB (310), in the second area (320a).

5. The electronic device (101) of claim 4,
wherein the first protrusions (901) are spaced apart from each other and asymmetrical with the second protrusions (902) with respect to the folding axis (237).

6. The electronic device (101) of any one of the preceding claims,
wherein each of the first area (310a) and the second area (320a) is recessed from another surface facing the hinge structure (260) toward the support plate (330).

7. The electronic device (101) claim 6,
wherein each of the first FPCB (310) and the second FPCB (320) includes:
a non-conductive layer (531, 532, 533) including conductive patterns (511, 512) disposed toward the support plate (330), and
functional layers disposed on a surface of the non-conductive layer (531, 532, 533) toward the hinge structure (260),
wherein a portion of the first area (310a) and the second area (320a) that is recessed toward the support plate (330) only includes the non-conductive layer (531, 532, 533), and
wherein another portion, which is distinct from the portion of the first area (310a) and the second area (320a), includes the non-conductive layer (531, 532, 533) and the functional layer.

8. The electronic device (101) of any one of the preceding claims,
wherein the flexible display (230) includes:
a first display area (231) disposed on the first housing (210),
a second display area (232) disposed on the second housing (220), and
a third display area (233) disposed between the first display area (231) and the second display area (232),
wherein the first FPCB (310) and the second FPCB (320) include an electromagnetic induction panel configured to receive an input signal through electromagnetic interaction with an external electronic device,
wherein the first FPCB (310) is disposed under the first display area (231) and a portion of the third display area (233), and
wherein the second FPCB (320) is disposed under the second display area (232) and another portion of the third display area (233).

9. The electronic device (101) of any one of the preceding claims,
wherein each of the first FPCB (310) and the second FPCB (320) includes:
a first non-conductive layer (531) in contact with a surface of the support plate (330),
a second non-conductive layer (532) in contact with another surface of the first non-conductive layer (531), and including a first conductive pattern (511) disposed on a surface facing the first non-conductive layer (531) and a second conductive pattern (512) disposed on another surface,
a third non-conductive layer (533) in contact with another surface of the second non-conductive layer (532),
a first adhesive layer (521) disposed between the first non-conductive layer (531) and the second non-conductive layer (532), and
a second adhesive layer (522) disposed between the second non-conductive layer (532) and the third non-conductive layer (533),
wherein each of the first FPCB (310) and the second FPCB (320) includes the first conductive pattern (511) among the first conductive pattern (511) and the second conductive pattern (512), in the first area (310a) or the second area (320a),
wherein the first non-conductive layer (531) is disposed on a remaining area distinct from the first area (310a) or the second area (320a), and
wherein the first adhesive layer (521) includes an inclined surface (521a) extending from a boundary of the first non-conductive layer (531) toward the folding axis (237).

10. The electronic device (101) of claim 9,
wherein the second non-conductive layer (532) includes at least one of epoxy or glass fiber.

11. The electronic device (101) of claim 8,
wherein the first FPCB (310) and the second FPCB (320) are configured to identify an external object approaching or contacting the third display area (233) of the flexible display (230) corresponding to the first FPCB (310) and the second FPCB (320).

12. The electronic device (101) of any one of the preceding claims,
wherein the support plate (330) includes carbon fiber reinforced plastic, CFRP, or metal.

13. The electronic device (101) of any one of the preceding claims,
wherein the flexible display (230) includes:
a first display area (231) disposed on the first housing (210),
a second display area (232) disposed on the second housing (220), and
a third display (233) area disposed between the first display area (231) and the second display area (232),
wherein the support plate (330) includes:
a first rigid area (331) corresponding to the first display area (231), and
a second rigid area (332) corresponding to the second display area (232),
wherein the flexible area (333) is disposed between the first rigid area (331) and the second rigid area (332).

14. The electronic device (101) of claim 8,
wherein the flexible display (230) includes a protection layer disposed between the display panel and the support plate (330) and across the third display area (233).

15. The electronic device (101) of claim 14,
wherein the protection layer is attached to the support plate (330) through an adhesive layer, and
wherein the adhesive layer is disposed on the support plate (330) corresponding to the first stdisplay area (231) and the second display area (232).

## Patentansprüche

1. Elektronische Vorrichtung (101), umfassend:
ein erstes Gehäuse (210);
ein zweites Gehäuse (220);
eine Scharnierstruktur (260), die dazu konfiguriert ist, das erste Gehäuse (210) und das zweite Gehäuse (220) in Bezug auf eine Faltachse (237) drehbar zu koppeln;
eine flexible Anzeige (230), umfassend:
ein Anzeigefeld (401) und
eine unter dem Anzeigefeld (401) angeordnete Stützplatte (330) zum Abstützen des Anzeigefelds (401), wobei die Stützplatte (330) einen flexiblen Bereich (333) mit einer Vielzahl von Schlitzen (334) zur Verformung eines Abschnitts der flexiblen Anzeige (230) umfasst;
eine erste flexible Leiterplatte, FPCB, (310), die auf dem ersten Gehäuse (210) und der Scharnierstruktur (260) angeordnet ist; und
eine zweite FPCB (320), die auf dem zweiten Gehäuse (220) und der Scharnierstruktur (260) angeordnet und von der ersten FPCB (310) beabstandet ist; wobei ein Spalt (g) zwischen der ersten FPCB (310) und der zweiten FPCB (320) unter dem flexiblen Bereich (333) der Stützplatte (330) definiert ist, und
wobei jeder von einem ersten Bereich (310a) der ersten FPCB (310), der unter dem flexiblen Bereich (333) angeordnet und einer Seitenfläche der zweiten FPCB (320) zugewandt ist, und einem zweiten Bereich (320a) der zweiten FPCB (320), der unter dem flexiblen Bereich (333) angeordnet und einer Seitenfläche der ersten FPCB (310) zugewandt ist, von einer der Stützplatte (330) zugewandten Oberfläche in Richtung der Scharnierstruktur (260) vertieft ist, um von der Stützplatte (330) beabstandet zu sein.

2. Elektronische Vorrichtung (101) nach Anspruch 1,
wobei die Faltachse (237) zwischen der ersten FPCB (310) und der zweiten FPCB (320) positioniert ist, und
wobei die Stützplatte (330) durch den Spalt (g) zwischen der ersten FPCB (310) und der zweiten FPCB (320) der Scharnierstruktur (260) zugewandt ist.

3. Elektronische Vorrichtung (101) nach einem der vorstehenden Ansprüche,
wobei jede von der ersten FPCB (310) und der zweiten FPCB (320) Folgendes umfasst:
eine nichtleitende Schicht (531, 532, 533) mit leitenden Mustern (511, 512), die zur Stützplatte (330) hin angeordnet sind, und
Funktionsschichten, die auf einer Oberfläche der nichtleitenden Schicht (531, 532, 533) in Richtung der Scharnierstruktur (260) angeordnet sind,
wobei ein Abschnitt des ersten Bereichs (310a) und des zweiten Bereichs (320a), der in Richtung der Scharnierstruktur (260) vertieft ist, nur die nichtleitende Schicht (531, 532, 533) umfasst, und
wobei ein weiterer Abschnitt, der sich von dem Abschnitt des ersten Bereichs (310a) und des zweiten Bereichs (320a) unterscheidet, die nichtleitende Schicht (531, 532, 533) und die Funktionsschicht umfasst.

4. Elektronische Vorrichtung (101) nach einem der vorstehenden Ansprüche,
wobei die erste FPCB (310) im ersten Bereich (310a) erste Vorsprünge (901) umfasst, die der Seitenfläche der zweiten FPCB (320) zugewandt sind, und
wobei die zweite FPCB (320) im zweiten Bereich (320a) zweite Vorsprünge (902) umfasst, die der Seitenfläche der ersten FPCB (310) zugewandt sind.

5. Elektronische Vorrichtung (101) nach Anspruch 4,
wobei die ersten Vorsprünge (901) voneinander beabstandet und in Bezug auf die Faltachse (237) asymmetrisch zu den zweiten Vorsprüngen (902) sind.

6. Elektronische Vorrichtung (101) nach einem der vorstehenden Ansprüche,
wobei jeder von dem ersten Bereich (310a) und dem zweiten Bereich (320a) von einer weiteren, der Scharnierstruktur (260) zugewandten Oberfläche in Richtung der Stützplatte (330) vertieft ist.

7. Elektronische Vorrichtung (101) nach Anspruch 6,
wobei jede von der ersten FPCB (310) und der zweiten FPCB (320) Folgendes umfasst:
eine nichtleitende Schicht (531, 532, 533) mit leitenden Mustern (511, 512), die zur Stützplatte (330) hin angeordnet sind, und
Funktionsschichten, die auf einer Oberfläche der nichtleitenden Schicht (531, 532, 533) in Richtung der Scharnierstruktur (260) angeordnet sind,
wobei ein Abschnitt des ersten Bereichs (310a) und des zweiten Bereichs (320a), der in Richtung der Stützplatte (330) vertieft ist, nur die nichtleitende Schicht (531, 532, 533) umfasst, und
wobei ein weiterer Abschnitt, der sich von dem Abschnitt des ersten Bereichs (310a) und des zweiten Bereichs (320a) unterscheidet, die nichtleitende Schicht (531, 532, 533) und die Funktionsschicht umfasst.

8. Elektronische Vorrichtung (101) nach einem der vorstehenden Ansprüche,
wobei die flexible Anzeige (230) Folgendes umfasst:
einen ersten Anzeigebereich (231), der auf dem ersten Gehäuse (210) angeordnet ist,
einen zweiten Anzeigebereich (232), der auf dem zweiten Gehäuse (220) angeordnet ist, und
einen dritten Anzeigebereich (233), der zwischen dem ersten Anzeigebereich (231) und dem zweiten Anzeigebereich (232) angeordnet ist,
wobei die erste FPCB (310) und die zweite FPCB (320) ein elektromagnetisches Induktionspanel umfassen, das dazu konfiguriert ist, ein Eingangssignal durch elektromagnetische Wechselwirkung mit einer externen elektronischen Vorrichtung zu empfangen,
wobei die erste FPCB (310) unter dem ersten Anzeigebereich (231) und einem Abschnitt des dritten Anzeigebereichs (233) angeordnet ist, und
wobei die zweite FPCB (320) unter dem zweiten Anzeigebereich (232) und einem weiteren Abschnitt des dritten Anzeigebereichs (233) angeordnet ist.

9. Elektronische Vorrichtung (101) nach einem der vorstehenden Ansprüche,
wobei jede von der ersten FPCB (310) und der zweiten FPCB (320) Folgendes umfasst:
eine erste nichtleitende Schicht (531), die mit einer Oberfläche der Stützplatte (330) in Kontakt steht,
eine zweite nichtleitende Schicht (532), die mit einer weiteren Oberfläche der ersten nichtleitenden Schicht (531) in Kontakt steht und ein erstes leitendes Muster (511), das auf einer der ersten nichtleitenden Schicht (531) zugewandten Oberfläche angeordnet ist, und ein zweites leitendes Muster (512), das auf einer weiteren Oberfläche angeordnet ist, umfasst,
eine dritte nichtleitende Schicht (533), die mit einer weiteren Oberfläche der zweiten nichtleitenden Schicht (532) in Kontakt steht,
eine erste Klebeschicht (521), die zwischen der ersten nichtleitenden Schicht (531) und der zweiten nichtleitenden Schicht (532) angeordnet ist, und
eine zweite Klebeschicht (522), die zwischen der zweiten nichtleitenden Schicht (532) und der dritten nichtleitenden Schicht (533) angeordnet ist,
wobei jede von der ersten FPCB (310) und der zweiten FPCB (320) in dem ersten Bereich (310a) oder dem zweiten Bereich (320a) das erste leitende Muster (511) unter dem ersten leitenden Muster (511) und dem zweiten leitenden Muster (512) umfasst,
wobei die erste nichtleitende Schicht (531) auf einem verbleibenden Bereich angeordnet ist, der sich von dem ersten Bereich (310a) oder dem zweiten Bereich (320a) unterscheidet, und
wobei die erste Klebeschicht (521) eine geneigte Oberfläche (521a) umfasst, die sich von einer Grenze der ersten nichtleitenden Schicht (531) in Richtung der Faltachse (237) erstreckt.

10. Elektronische Vorrichtung (101) nach Anspruch 9,
wobei die zweite nichtleitende Schicht (532) mindestens eines von Epoxidharz und Glasfaser umfasst.

11. Elektronische Vorrichtung (101) nach Anspruch 8,
wobei die erste FPCB (310) und die zweite FPCB (320) dazu konfiguriert sind, ein externes Objekt identifizieren, das sich dem dritten Anzeigebereich (233) der flexiblen Anzeige (230) nähert oder diesen berührt, der der ersten FPCB (310) und der zweiten FPCB (320) entspricht.

12. Elektronische Vorrichtung (101) nach einem der vorstehenden Ansprüche,
wobei die Stützplatte (330) carbonfaserverstärkten Kunststoff, CFK, oder Metall umfasst.

13. Elektronische Vorrichtung (101) nach einem der vorstehenden Ansprüche,
wobei die flexible Anzeige (230) Folgendes umfasst:
einen ersten Anzeigebereich (231), der auf dem ersten Gehäuse (210) angeordnet ist,
einen zweiten Anzeigebereich (232), der auf dem zweiten Gehäuse (220) angeordnet ist, und
einen dritten Anzeigebereich (233), der zwischen dem ersten Anzeigebereich (231) und dem zweiten Anzeigebereich (232) angeordnet ist,
wobei die Stützplatte (330) Folgendes umfasst:
einen ersten starren Bereich (331), der dem ersten Anzeigebereich (231) entspricht, und
einen zweiten starren Bereich (332), der dem zweiten Anzeigebereich (232) entspricht,
wobei der flexible Bereich (333) zwischen dem ersten starren Bereich (331) und dem zweiten starren Bereich (332) angeordnet ist.

14. Elektronische Vorrichtung (101) nach Anspruch 8,
wobei die flexible Anzeige (230) eine Schutzschicht umfasst, die zwischen dem Anzeigefeld und der Stützplatte (330) und über den dritten Anzeigebereich (233) hinweg angeordnet ist.

15. Elektronische Vorrichtung (101) nach Anspruch 14,
wobei die Schutzschicht über eine Klebeschicht an der Stützplatte (330) angebracht ist, und
wobei die Klebeschicht auf der Stützplatte (330) entsprechend dem ersten Anzeigebereich (231) und dem zweiten Anzeigebereich (232) angeordnet ist.

## Revendications

1. Dispositif électronique (101) comprenant :
un premier boîtier (210) ;
un second boîtier (220) ;
une structure de charnière (260) configurée pour coupler de manière rotative le premier boîtier (210) et le second boîtier (220) par rapport à un axe de pliage (237) ;
un écran flexible (230) comprenant :
un panneau d'affichage (401), et
une plaque de support (330) disposée sous le panneau d'affichage (401) pour supporter le panneau d'affichage (401), dans lequel la plaque de support (330) comprend une zone flexible (333) comprenant une pluralité de fentes (334) pour la déformation d'une partie de l'écran flexible (230) ;
une première carte de circuit imprimé flexible, FPCB, (310) disposée sur le premier boîtier (210) et la structure de charnière (260) ; et
une seconde FPCB (320) disposée sur le second boîtier (220) et la structure de charnière (260) et espacée de la première FPCB (310) ; dans lequel un espace (g) entre la première FPCB (310) et la seconde FPCB (320) est défini sous la zone flexible (333) de la plaque de support (330), et
dans lequel chacune d'une première zone (310a) de la première FPCB (310), disposée sous la zone flexible (333), faisant face à une surface latérale de la seconde FPCB (320), et d'une seconde zone (320a) de la seconde FPCB (320), disposée sous la zone flexible (333), faisant face à une surface latérale de la première FPCB (310), est évidée depuis une surface faisant face à la plaque de support (330) vers la structure de charnière (260) de manière à être espacée de la plaque de support (330).

2. Dispositif électronique (101) selon la revendication 1,
dans lequel l'axe de pliage (237) est positionné entre la première FPCB (310) et la seconde FPCB (320), et
dans lequel la plaque de support (330) fait face à la structure de charnière (260) à travers l'espace (g) entre la première FPCB (310) et la seconde FPCB (320).

3. Dispositif électronique (101) selon l'une quelconque des revendications précédentes,
dans lequel chacune de la première FPCB (310) et de la seconde FPCB (320) comprend :
une couche non conductrice (531, 532, 533) comprenant des motifs conducteurs (511, 512) disposés vers la plaque de support (330), et
des couches fonctionnelles disposées sur une surface de la couche non conductrice (531, 532, 533) vers la structure de charnière (260),
dans lequel une partie de la première zone (310a) et de la seconde zone (320a) qui est évidée vers la structure de charnière (260) comprend uniquement la couche non conductrice (531, 532, 533), et
dans lequel une autre partie distincte de ladite partie de la première zone (310a) et de la seconde zone (320a) comprend la couche non conductrice (531, 532, 533) et la couche fonctionnelle.

4. Dispositif électronique (101) selon l'une quelconque des revendications précédentes,
dans lequel la première FPCB (310) comprend des premières saillies (901) faisant face à la surface latérale de la seconde FPCB (320), dans la première zone (310a), et
dans lequel la seconde FPCB (320) comprend des secondes saillies (902) faisant face à la surface latérale de la première FPCB (310), dans la seconde zone (320a).

5. Dispositif électronique (101) selon la revendication 4,
dans lequel les premières saillies (901) sont espacées les unes des autres et asymétriques par rapport aux secondes saillies (902) par rapport à l'axe de pliage (237).

6. Dispositif électronique (101) selon l'une quelconque des revendications précédentes,
dans lequel chacune de la première zone (310a) et de la seconde zone (320a) est évidée depuis une autre surface faisant face à la structure de charnière (260) vers la plaque de support (330).

7. Dispositif électronique (101) selon la revendication 6,
dans lequel chacune de la première FPCB (310) et de la seconde FPCB (320) comprend :
une couche non conductrice (531, 532, 533) comprenant des motifs conducteurs (511, 512) disposés vers la plaque de support (330), et
des couches fonctionnelles disposées sur une surface de la couche non conductrice (531, 532, 533) vers la structure de charnière (260),
dans lequel une partie de la première zone (310a) et de la seconde zone (320a) qui est évidée vers la plaque de support (330) comprend uniquement la couche non conductrice (531, 532, 533), et
dans lequel une autre partie, qui est distincte de ladite partie de la première zone (310a) et de la seconde zone (320a), comprend la couche non conductrice (531, 532, 533) et la couche fonctionnelle.

8. Dispositif électronique (101) selon l'une quelconque des revendications précédentes,
dans lequel l'écran flexible (230) comprend :
une première zone d'affichage (231) disposée sur le premier boîtier (210),
une seconde zone d'affichage (232) disposée sur le second boîtier (220), et
une troisième zone d'affichage (233) disposée entre la première zone d'affichage (231) et la seconde zone d'affichage (232),
dans lequel la première FPCB (310) et la seconde FPCB (320) comprennent un panneau à induction électromagnétique configuré pour recevoir un signal d'entrée par interaction électromagnétique avec un dispositif électronique externe,
dans lequel la première FPCB (310) est disposée sous la première zone d'affichage (231) et une partie de la troisième zone d'affichage (233), et
dans lequel la seconde FPCB (320) est disposée sous la seconde zone d'affichage (232) et une autre partie de la troisième zone d'affichage (233).

9. Dispositif électronique (101) selon l'une quelconque des revendications précédentes,
dans lequel chacune de la première FPCB (310) et de la seconde FPCB (320) comprend :
une première couche non conductrice (531) en contact avec une surface de la plaque de support (330),
une seconde couche non conductrice (532) en contact avec une autre surface de la première couche non conductrice (531), et comprenant un premier motif conducteur (511) disposé sur une surface faisant face à la première couche non conductrice (531) et un second motif conducteur (512) disposé sur une autre surface,
une troisième couche non conductrice (533) en contact avec une autre surface de la seconde couche non conductrice (532),
une première couche adhésive (521) disposée entre la première couche non conductrice (531) et la seconde couche non conductrice (532), et
une seconde couche adhésive (522) disposée entre la seconde couche non conductrice (532) et la troisième couche non conductrice (533),
dans lequel chacune de la première FPCB (310) et de la seconde FPCB (320) comprend le premier motif conducteur (511) parmi le premier motif conducteur (511) et le second motif conducteur (512), dans la première zone (310a) ou la seconde zone (320a),
dans lequel la première couche non conductrice (531) est disposée sur une zone restante distincte de la première zone (310a) ou de la seconde zone (320a), et
dans lequel la première couche adhésive (521) comprend une surface inclinée (521a) s'étendant depuis une limite de la première couche non conductrice (531) vers l'axe de pliage (237).

10. Dispositif électronique (101) selon la revendication 9,
dans lequel la seconde couche non conductrice (532) comprend au moins l'un parmi de l'époxy et de la fibre de verre.

11. Dispositif électronique (101) selon la revendication 8,
dans lequel la première FPCB (310) et la seconde FPCB (320) sont configurées pour identifier un objet externe s'approchant de la troisième zone d'affichage (233) de l'écran flexible (230) correspondant à la première FPCB (310) et à la seconde FPCB (320), ou entrant en contact avec celle-ci.

12. Dispositif électronique (101) selon l'une quelconque des revendications précédentes,
dans lequel la plaque de support (330) comprend du plastique renforcé de fibres de carbone, CFRP, ou du métal.

13. Dispositif électronique (101) selon l'une quelconque des revendications précédentes,
dans lequel l'écran flexible (230) comprend :
une première zone d'affichage (231) disposée sur le premier boîtier (210),
une seconde zone d'affichage (232) disposée sur le second boîtier (220), et
une troisième zone d'affichage (233) disposée entre la première zone d'affichage (231) et la seconde zone d'affichage (232),
dans lequel la plaque de support (330) comprend :
une première zone rigide (331) correspondant à la première zone d'affichage (231), et
une seconde zone rigide (332) correspondant à la seconde zone d'affichage (232),
dans lequel la zone flexible (333) est disposée entre la première zone rigide (331) et la seconde zone rigide (332).

14. Dispositif électronique (101) selon la revendication 8,
dans lequel l'écran flexible (230) comprend une couche de protection disposée entre le panneau d'affichage et la plaque de support (330) et sur toute la troisième zone d'affichage (233).

15. Dispositif électronique (101) selon la revendication 14,
dans lequel la couche de protection est fixée à la plaque de support (330) par l'intermédiaire d'une couche adhésive, et
dans lequel la couche adhésive est disposée sur la plaque de support (330) correspondant à la première zone d'affichage (231) et à la seconde zone d'affichage (232).
